# EUROPÄISCHE PATENTSCHRIFT

(11) **EP 1 925 015 B1**
(45) Veröffentlichungstag und Bekanntmachung des Hinweises auf die Patenterteilung: **17.11.2010**
(21) Anmeldenummer: 06774775.8
(22) Anmeldetag: 12.09.2006
(51) Int. Cl.: H01J 37/32

(54) **ANLAGE ZUR PLASMAPROZESSIERUNG VON ENDLOSMATERIAL**
SYSTEM FOR PLASMA TREATMENT OF ENDLESS MATERIALS
INSTALLATION DE TRAITEMENT AU PLASMA D'UN MATERIAU SANS FIN

(30) Priorität: 12.09.2005 AT 14962005
(43) Veröffentlichungstag der Anmeldung: 28.05.2008
(73) Patentinhaber: Ziger, Peter, A-8010 Graz (AT); Eiselt, Primoz, 2211 Pesnica pri Mariboro (SI)
(72) Erfinder: Ziger, Peter, A-8010 Graz (AT); Eiselt, Primoz, 2211 Pesnica pri Mariboro (SI)
(74) Vertreter: Margotti, Herwig Franz
(86) Internationale Anmeldenummer: PCT/AT2006/000377
(87) Internationale Veröffentlichungsnummer: WO 2007/030850

(56) Entgegenhaltungen:
- WO-A2-2004/073009
- WO-A2-2005/010228
- DE-A1- 10 361 908
- US-A- 6 083 355
- US-A1- 2005 145 174
- US-B1- 6 818 853

## Beschreibung

Die Erfindung betrifft eine Anlage zur Plasmaprozessierung eines Endlosmaterials mit zumindest einer evakuierbaren Entladungskammer, durch die hindurch das Endlosmaterial kontinuierlich transportierbar ist, wobei jede Entladungskammer eine Außenelektrode aufweist, die in Bezug auf das Endlosmaterial elektrisch isoliert angeordnet ist, einer Einrichtung zur Einstellung einer Gasatmosphäre in der wenigstens einen Entladungskammer, und einer Energieversorgungseinrichtung zur Abgabe von elektrischer Entladungsenergie an zwischen der Außenelektrode einer jeweiligen Entladungskammer und dem Endlosmaterial als Innenelektrode definierte Entladungsstrecken.

Plasmaprozessierung unter Verwendung von Glimmentladungsplasma wird zur flächendeckenden Behandlung von Werkstücken oder Endlosmaterialien bei Unterdruck angewandt, wobei die Behandlung beispielsweise das Erhitzen, Reinigen, (De-)Oxidieren, Entfetten, Bedampfen, Sputtern etc. umfasst. Es kann sowohl die physikalische wie auch die chemische Wirkung des Plasmas benutzt werden.

All diesen Behandlungen ist gemeinsam, dass es erwünscht ist, dass die Entladung flächendeckend über die behandelten Werkstückoberflächen oder Endlosmaterialoberflächen brennt. Aus wirtschaftlichen Gründen wird eine möglichst kurze Behandlungszeit angestrebt, was wiederum zur Forderung nach einer möglichst hohen Behandlungsintensität (möglichst hoher Leistungsdichte) führt. Im Allgemeinen ist die Grenze der Energieeinkoppelbarkeit bei Prozessdrücken im viskosen Vakuumbereich (wo die freien Weglängen der Gasteilchen wesentlich kleiner sind als die der Gefäßabmessungen) dadurch gegeben, dass eine Entladung mit Glimm- oder glimmähnlicher Charakteristik bei zu hohen Leistungsdichten die Tendenz aufweist, in eine Bogenentladung umzuschlagen. Das Unterdrücken dieses Umschlagens von der Glimmentladung zur einer Bogenentladung ist im Allgemeinen eines der wichtigsten Ziele bei der Entwicklung von Prozessen und Anlagen, die im Unterdruckbereich Plasma prozessieren, sofern keine punktförmige Behandlung (wie z.B. beim Schweißen) erwünscht ist. Ein wichtiger Schritt zu Erreichung dieses Zieles war die Einführung von Spannungsquellen als Energieversorgungseinrichtungen zur Abgabe von elektrischer Entladungsenergie, die mit gepulster Gleichspannung arbeiten. Ein Lichtbogen braucht Zeit um sich zu bilden. Durch die wiederkehrenden Pausen im Entladungsspannungsverlauf zerbläst sich ein Lichtbogen, bevor es zu starken örtlichen Aufheizungen kommt. Innerhalb eines Pulses steigt der Strom monoton an, im Allgemeinen anfangs näherungsweise linear, später verringert sich die Anstiegsgeschwindigkeit. Die Spannung während des Pulses bleibt bei den meisten Anwendungen aus technischen Gründen näherungsweise konstant. Eine Anlage zur Plasmaprozessierung von Endlosmaterialien, bei der gepulste Gleichspannungsquellen als Energieversorgungseinrichtungen eingesetzt werden, ist z.B. aus der PCT-Anmeldung WO 2004/073009 A2 bekannt.

Wie beispielsweise in dem Dokument US 2004/0026412 A1 beschrieben, können an Stelle der gepulsten Gleichspannung andere zeitliche Spannungsverläufe eingesetzt werden, um einen sich im Entstehungsstatus befindenden Lichtbogen wieder zum Erlöschen zu bringen. Die technische Bedeutung solcher von gepulster Gleichspannung abweichender Spannungsverläufe ist jedoch gering, da sie einen erhöhten technischen Aufwand mit sich bringen, ohne einen erkennbaren Vorteil beim Entladungsprozess zu bieten.

Obwohl eine gepulste Spannungsversorgung einen großen Fortschritt in der Plasmatechnologie gebracht hat, blieben viele Schwächen bestehen. Insbesondere konnten die folgenden Probleme und Nachteile bis jetzt nicht zufriedenstellend gelöst werden:
1. Im Verlauf eines Gleichspannungspulses steigt die Wahrscheinlichkeit, dass die Glimmentladung in eine Bogenentladung umschlägt, mit der Zeit extrem progressiv an. Den Umschlag zur Bogenentladung begünstigen drei Faktoren: Strom, Spannung und Zeit. So gesehen ist es ungünstig, dass im Verlauf des Pulses zwei dieser Faktoren (Strom und Zeit) wachsen und der dritte Faktor (Spannung) konstant bleibt.
2. Der Übergang von einer Glimm- zu einer Bogenentladung wird elektrisch als Impedanzverkleinerung der Entladungsstrecke wahrgenommen. Es wurden bereits Regelungen entwickelt, die das Auftreten dieser Impedanzverkleinerung detektieren und in diesem Fall die Spannung für einen bestimmten Zeitraum aussetzen, um den Lichtbogen zum Verlöschen zu bringen. Allerdings benötigen sowohl die Detektion der Impedanzverkleinerung als auch die Abschaltung der Spannungszufuhr eine bestimmte Ansprechzeit, die nicht beliebig kurz gemacht werden kann. Während dieser Ansprechzeit wächst der Strom bei annähernd konstanter Spannung, die Energie nimmt also zu, was eine unerwünschte Aufheizung des Bogens bewirkt. So kann sich ein Lichtbogen mit großem Energieinhalt bilden, der nur schwer (durch Aussetzen mehrerer Pulse) zu "zerblasen" ist.
3. Vor allem bei niedrig schmelzenden Materialien kann das Auftreten eines Lichtbogens sofort Oberflächenbeschädigungen hervorrufen.
4. Ein weiteres großes Problem tritt auf, wenn die Gaszusammensetzung im Entladungsraum nicht konstant ist. Dies ist insbesondere immer dann der Fall, wenn das Plasma zur Reinigung von Materialien eingesetzt wird bzw. wenn die Oberflächen der Elektroden Materie in die Gasphase abgeben können. Da die zu behandelnden Materialien im Allgemeinen unterschiedlich verunreinigt sind und das Plasma auch nicht exakt die gleiche Behandlungsintensität aufweist, ändert sich die durch das Plasma von den Oberflächen des Materials in die Gasphase beförderte Verunreinigungsmenge mit der Zeit. Diese Änderungen sind nicht vorhersehbar oder kontrollierbar und führen somit zu einer unkontrollierbaren Veränderung der Gaszusammensetzung in der Entladungskammer. Im Plasma konkurrieren ständig zwei Vorgänge, von denen einer der Entladung selbst sowie der Entladungsstabilität förderlich und der andere den beiden schädlich ist: im Glimmentladungsplasma werden bei Unterdruck Elektronen beschleunigt, bis sie auf Gasteilchen auftreffen. Im günstigen Fall kann ein Elektron das getroffene Gasteilchen ionisieren und bildet hiermit ein neues Elektronen-Ionenpaar. Im ungünstigsten Fall verliert das Elektron seine Energie durch Anregung des getroffenen Gasteilchens. Einzelne Atome (vor allem Edelgasatome, in kleinerem Maß aber auch kleine Moleküle) besitzen vor allem bei niedrigen Energien weit auseinander liegende, diskrete, quantenmechanisch zugelassene Energieniveaus, so dass die Wahrscheinlichkeit, dass ein Elektron bei einem Stoss mit einem solchen Atom dieses anregt und dabei seine Energie an das Atom abgibt, sehr gering ist. Umgekehrt besitzen Moleküle, vor allem größere organische Moleküle, aus denen Verunreinigungen typischerweise bestehen, eine viel größere Anzahl von quantenmechanisch zugelassenen Zuständen, von denen etliche niederenergetisch sind. Stößt ein Elektron gegen ein solches Molekül, so ist die Wahrscheinlichkeit hoch, dass es dieses Molekül anregt, wodurch dem Elektron die Energie entzogen wird.

Elektrisch stellt sich die Präsenz solcher Moleküle im Entladungsraum als eine Impedanzerhöhung der Entladungsstrecke dar. Noch ausgeprägter wird die Impedanzerhöhung, wenn in die Gasphase Teichen befördert werden, die den Elektronen nicht nur Elektronenenergie, sondern dem Plasma die Elektronen selbst entziehen.

Da bei einer auf Glimmentladung basierenden Plasmabehandlungsanlage, in der auch Substratreinigung stattfindet, zum Abtransport der durch die Entladung in die Gasphase beförderten Verunreinigungen im allgemeinen hohe Gasgeschwindigkeiten eingestellt werden und die Zufuhr der Verschmutzungen in die Gasphase sich zeitlich sehr schnell ändert, ändert sich somit schnell und nicht kontrollierbar die Gaszusammensetzung, daraus folglich die Impedanz, somit auch der Entladungsstrom. Vor allem bei Behandlung von Endlosmaterialien in einem Durchlaufverfahren erfolgt diese Impedanzänderung so schnell, dass selbst sehr schnelle Regelmechanismen der Spannungsquelle die elektrischen Parameter der Entladung nicht so nachregeln können, dass die Entladungsleistung oder der Endladungsstrom konstant gehalten werden kann. Gerade dies wäre aber bei einer Endlosbehandlung besonders wichtig, da durch die kurze Verweilzeit eines Endlosmaterialabschnittes in der Entladungszone keine effiziente zeitliche Mittelung des Behandlungsprozesses stattfinden kann.
5. Eine weitere, ähnliche Problematik der Beeinträchtigung der Entladungskonstanz bei Behandlung von Materialien, deren Oberflächen nicht sauber sind, tritt auf, weil die Entladung von der Sekundärelektronenemission an der Kathode (die im Allgemeinen durch das zu behandelnde Material gebildet ist) maßgeblich beeinflusst wird. Ist dieses ungleichmäßig verschmutzt, ändert sich entsprechend die Sekundärelektronenemission und somit die Impedanz. Die Auswirkungen sind einerseits ähnlich wie in obigem Punkt erläutert, des weiteren wird eine ungleichmäßige Beschlagung der zu behandelnden Oberfläche mit Plasma gefördert, was zu örtlichen Entladungsverdichtungen und folglich zur Bogenbildung führt. So können mit bestimmten Verunreinigungen beschlagene Oberflächen mit Anlagen nach dem Stand der Technik gar nicht prozessiert werden, weil trotz kleiner Verschmutzungsmenge der Kathode die Entladung schon bei verschwindend kleinen Behandlungsleistungen in Bogenentladungen übergeht.
6. Vor allem beim Behandeln von Endlosmaterialen, die mit hoher Behandlungsintensität bearbeitet werden sollen, stellt sich noch ein weiteres Problem ein. Oft erweist es sich als vorteilhaft, das Endlosmaterial durch mehrere Entladungszonen hintereinander zu bewegen, um mehr Leistung einkoppeln zu können, ohne dass beim Umschlagen in eine Bogenentladung die gesamte hohe Leistung auf einen Punkt konzentriert wird, sondern nur jene Leistung der entsprechenden Behandlungseinheit. Jede dieser Entladungszonen kann eine separate Versorgung mit Gas und Energie besitzen. Dabei kann das Endlosmaterial, das ja als eine Elektrode der elektrischen Entladung fungiert, in vielen Fällen aus thermischen Gründen nur vor der ersten und nach der letzten Behandlungseinheit kontaktiert werden, um den Strom der Entladung wieder abzuleiten. Selbst wenn für jede Entladungszone eine separate Spannungs- und Gasversorgung zu Verfügung steht, können dabei die Wechselwirkungen der Behandlungszonen untereinander den Prozess vollkommen unstabil machen. Schafft man es dennoch, in die einzelnen Behandlungszonen hohe Ströme einzuleiten, stellt sich wiederum am Endlosmaterial ein nicht vernachlässigbarer Spannungsabfall ein, da diese Ströme zu den außerhalb der Behandlungszonen liegenden Kontaktierungen abgeleitet werden. Bei Plasmaprozessierungsanlagen, bei denen gepulste Gleichspannungsquellen als Entladungsenergiequellen verwendet werden, ist das Potential an einer jeden Stelle des Endlosmaterials, die um mindestens eine Entladungsstrecke von der nächsten Kontaktierung entfernt ist, nicht bekannt. Es genügen oftmals relativ kleine Potentialabweichungen von dem Potential der Kontaktierungen, um die Spannungsquellen und damit die Entladungsprozesse in der Mitte der Behandlungsstrecke unstabil werden zu lassen.
7. Bei Behandlungen von Endlosmaterialien, die sehr hohe Temperaturen erfordern (z.B. Glühen von Hochtemperaturmaterialien) tritt ein weiteres Problem auf. Wird an der Endlosmaterialoberfläche eine Temperatur erreicht, die nahe jener Temperatur liegt, bei der eine spontane Elektronenemission stattfindet, dann ist ein gleichmäßiges Behandeln nicht mehr möglich, weil die Sekundärelektronenprodulction stark mit der Temperatur ansteigt. Somit behandelt das Plasma hier die heißeren Stellen des Endlosmaterials intensiver, eine weitere Überhitzung dieser Stellen ist die prozessschädigende Folge. Abhilfe könnte ein Aufteilen der Behandlungsstrecke in kurze, getrennt mit Leistung versorgte Segmente bringen. Dabei bewirkt jedes Segment nur eine kleine Temperaturerhöhung des Endlosmaterials. Je höher die benötigte Behandlungstemperatur, desto kleiner muss die Temperaturerhöhung pro Segment ausfallen. Nun ist aber gerade bei hohen Temperaturen die Kontaktierung des Endlosmaterials zwischen den Segmenten zwingend mit Beschädigungen der Endlosoberfläche verbunden.

Die Aufgabe der Erfindung besteht darin, eine Anlage zur Plasmaprozessierung eines Endlosmaterials bereitzustellen, bei der die geschilderten Nachteile des Standes der Technik vermieden oder zumindest wesentlich gemildert sind.

In einem ersten Ansatz wird diese Aufgabe erfindungsgemäß durch eine Anlage zur Plasmaprozessierung eines Endlosmaterials mit den Merkmalen des Anspruchs 1 gelöst. Vorteilhafte Ausgestaltungen der Erfindung sind in den Unteransprüchen dargelegt.

Die erfindungsgemäße Anlage zur Plasmaprozessierung eines Endlosmaterials umfasst zumindest eine evakuierbaren Entladungskammer, durch die hindurch das Endlosmaterial kontinuierlich transportierbar ist, wobei jede Entladungskammer eine Außenelektrode aufweist, die in Bezug auf das Endlosmaterial elektrisch isoliert angeordnet ist. Die Anlage umfasst weiter eine Einrichtung zur Einstellung einer Gasatmosphäre in der wenigstens einen Entladungskammer, und eine Energieversorgungseinrichtung zur Abgabe von elektrischer Entladungsenergie an zwischen der Außenelektrode einer jeweiligen Entladungskammer und dem Endlosmaterial als Innenelektrode definierte Entladungsstrecken. Die erfindungsgemäße Anlage zur Plasmaprozessierung von Endlosmaterial zeichnet sich dadurch aus, dass die Energieversorgungseinrichtung eine zur pulsförmigen Abgabe der Entladungsenergie ausgebildete inhärente Stromquelle ist, die zumindest eine Induktivität als Energiespeicher aufweist, die mit einer ihr zugeordneten Entladungsstrecke oder sukzessive mit mehreren ihr zugeordneten Entladungsstrecken zusammenschaltbar ist. Durch diese Maßnahme ist gewährleistet, dass die Energieabgabe an die den jeweiligen Induktivitäten zugeordneten Entladungsstrecken unter weitgehender Konstanthaltung des elektrischen Entladungsstroms erfolgt. Die Konstanthaltung des elektrischen Entladungsstroms erfolgt dabei unabhängig von einem Eingriff eines Regel-oder Steuerelements, d.h. die Induktivitäten wirken als "inhärente" Konstantstromquellen. Dies ist ein wesentlicher Unterschied zum Stand der Technik, da die Konstantstromquelle die Entstehung von Lichtbögen weitgehend verhindert, da während der Entladung keine Erhöhung des an die Entladungsstrecke abgegebenen elektrischen Stroms auftritt. Vielmehr wird durch die Induktivität der an die Entladungsstrecke abgegebene Strom daran gehindert, sich selbst bei etwaigen schnellen und/oder großen Impedanzänderungen der Entladungsstrecke schnell zu ändern, so dass während der einzelnen Pulse eine zeitlich konstante, dem Energieverlust entsprechend abnehmende, auf jeden Fall aber keine Unstetigkeiten besitzende Stromdurchfließung einer jeden Entladungsstrecke näherungsweise unabhängig von Impedanzänderungen - selbst unstetigen - gegeben ist, wobei eine jede Entladung ein in Bezug auf die Entladungskammer wesentliches Volumen einnimmt und zumindest die innenliegende Elektrode, d.h. das Endlosmaterial, flächig beschlägt.

Es sei weiters darauf hingewiesen, dass bis dato keine kommerziell einsetzbare elektronische Leistungsregelungsschaltung ausreichend schnell reagieren kann, um die Entstehung eines Lichtbogens zu verhindern bzw. im Keim zu ersticken. Die vorliegende Erfindung stellt somit eine wesentliche Weiterentwicklung dar, da sie die Lichtbogenentwicklung mit einem viel kürzeren Aussetzen der Entladungsenergiezufuhr, oft aber sogar gänzlich ohne Eingriff der elektronischen Leistungsregelung unterdrücken kann.

Die Induktivitäten der Energieversorgungseinrichtung können z.B. als diskrete Energiespeicherspulen oder als Wicklungen eines Transformators ausgeführt sein, wobei im letzteren Fall die Energieeinbringung über eine weitere Transformatorwicklung erfolgt.

Speziell bei Anwendungen, die hohe Behandlungstemperaturen erfordern, ist es wichtig, die Plasmaprozessierungsstrecke in mehrere Entladungsstrecken zu unterteilen, wobei die zumindest eine Induktivität während eines Energieabgabepulses zu jedem Zeitpunkt eines jeden Pulses mit genau einer Entladungsstrecke zusammengeschaltet wird. Falls eine Induktivität für die Energieversorgung von mehr als einer Entladungsstrecke zuständig ist, erfolgt die Umschaltung zu einer anderen Entladungsstrecke vorzugsweise in den Energieabgabepulspausen dieser Induktivität.

In alternativen Ausgestaltungen der Erfindung kann die Induktivität je nach Auslegung der Energieversorgungseinrichtung entweder nur während der Energieabgabepulse oder nur während der Energieabgabepulspausen geladen werden.

Des weiteren ist es sinnvoll, wenn die Energieversorgungseinrichtung eine Ausgangsspannungsbegrenzungsschaltung aufweist, da die Impedanz des Plasmas am Pulsanfang sehr hoch sein kann und der konstante Strom in der Induktivität ansonsten einen unkontrollierten und sowohl für den Prozess wie auch die Anlage und deren Umgebung gefährlichen Spannungsanstieg bewirken könnte.

Für verschiedene Prozesse kann es von Vorteil sein, wenn die Energieversorgungseinrichtung ein elektronisches Schaltwerk zur Abgabe von Energiepulsen beliebiger Polarität an die Entladungsstrecke aufweist. Beispielsweise kann für eine leichtere Zündung, vor allem aber zur Selbstreinigung der Anlage jeder x-te Energiepuls mit umgekehrter Polarität abgegeben werden.

In einer Fortbildung der erfindungsgemäßen Anlage ist weiters vorgesehen, dass zwischen der zumindest einen Induktivität der Energieversorgungseinrichtung und der zumindest einen Entladungskammer zumindest eine Entzenschaltung angeordnet ist, um die parasitären Hochfrequenzeffekte bzw. deren Einflüsse, wie z. B. die Induktivität der Stromleiter, die Kapazität der Entladungskammer bzw. der Elektroden u. Ä. zu unterdrücken bzw. zu kompensieren.

Speziell für Hochtemperaturbehandlungen eines Endlosmaterials sind in einer Ausgestaltung der Erfindung mehrere Entladungskammern hintereinander angeordnet, durch die das Endlosmaterial hindurchläuft, ohne in oder zwischen den Entladungskammern kontaktiert zu werden. Dadurch wird eine Oberflächenbeschädigung des Endlosmaterials verhindert.

In einem zweiten Ansatz zur Lösung der erfindungsgemäßen Aufgabe ist bei einer erfindungsgemäßen Anlage zur Plasmaprozessierung eine Hochleistungsmagnetanordnung vorgesehen, die im Bereich der Außenelektrode ein starkes, im wesentlichen parallel mit dem Endlosmaterial ausgerichtetes Magnetfeld von zumindest 120 mT, vorzugsweise von zumindest 400 mT, am bevorzugtesten von zumindest 700 mT, erzeugt. Auf diese Weise wird eine beträchtliche Erhöhung der Energiedichte der Gasentladung erzielt. Durch die Erzeugung derart starker Magnetfelder werden besonders hohe Plasmastromdichten ermöglicht, die auch die Reinigung stark verschmutzter Endlosmaterialien ermöglichen, bei denen nach dem Stand der Technik die Gasentladung aufgrund von in die Gasphase beförderten Teilchen, die den Elektronen nicht nur Elektronenenergie, sondern dem Plasma die Elektronen selbst entziehen, zum Erliegen kommen würde.

Durch das angelegte Magnetfeld wird das Plasma leitfähiger, so dass die Entladung vorzugsweise nur im magnetfelddurchdrungenen Volumen brennt.

Um eine möglichst gleichmäßige Entladung und damit eine homogene Behandlung zu erzielen, ist weiter vorgesehen, dass die Hochleistungsmagnetanordnung dazu ausgebildet ist, ein über den Verlauf seiner Längsausdehnung im Wesentlichen homogenes Magnetfeld zu erzeugen. Um ein solches homogenes Magnetfeld zu erzeugen, ist es bevorzugt, wenn die Hochleistungsmagnetanordnung eine die Außenelektrode umgebende Spule ist, die im Wesentlichen koaxial mit dem Endlosmaterial angeordnet ist, wobei die Spule vorzugsweise als gekühlte, insbesondere flüssigkeitsgekühlte, Spule, optional als supraleitender Elektromagnet ausgebildet ist. Durch die Spulenkühlung werden höhere Betriebsleistungen ermöglicht.

Für andere Plasmaprozessierungsanwendungen kann es zweckmäßig sein, wenn die Hochleistungsmagnetanordnung dazu ausgebildet ist, ein über den Verlauf seiner Längsausdehnung inhomogenes Magnetfeld zu erzeugen, dessen Maxima die Maxima der Behandlungsintensität des Endlosmaterials selbst bei Vorhandensein von Faktoren mit gegenteiligen Tendenzen fixieren. Dabei ist zweckmäßig die Hochleistungsmagnetanordnung als Permanentmagnetanordnung ausgebildet, die insbesondere anisotrope Permanentmagneten, vorzugsweise aus NdFeB-Permanentmagneten, umfasst, welche im Wesentlichen die Seitenwände eines Prismas mit polygonalem Querschnitt bilden, wobei die Magnetisierungsrichtung der Magnete vorzugsweise im Wesentlichen radial in Bezug auf den Querschnitt des Prismas verläuft. Durch diese Ausgestaltung wird ein kostengünstiger Betrieb der Anlage ermöglicht, da zur Erzeugung des Magnetfelds keine Kühlung und kein elektrischer Strom erforderlich sind. Durch den Aufbau einer Permanentmagnetanordnung in Form eines Prismas können günstige Magnetfeldverläufe in der Entladungskammer einfach realisiert werden. Der Einsatz anisotroper Permanentmagneten, vorzugsweise aus NdFeB-Permanentmagneten, ermöglicht die Erzeugung besonders starker Magnetfelder.

Durch das Vorsehen von Eisenschlusselementen, die das Magnetfeld der Permanentmagnetanordnung im Bereich der Gasentladung konzentrieren, kann kostengünstig die Wirkung der Permanentmagneten im Bereich der Gasentladung deutlich erhöht werden.

Um zu erreichen, dass die Entladung vollständig innerhalb der Magnetfeldzone brennt und nicht über diese Magnetfeldzone hinaus brennt, ist weiters vorgesehen, dass die Außenelektrode in ihrer Längserstreckung nicht aus dem Magnetfeld herausragt.

In einer alternativen Ausführungsform der Erfindung ragt die Außenelektrode in ihrer Längserstreckung an mindestens einer Seite aus dem Magnetfeld heraus, wodurch die Entladung in Längsrichtung an dieser Seite bzw. an diesen Seiten am Ende des Magnetfelds kontinuierlich in eine gewöhnliche Glimmentladung übergeht, die von da an das Endlosmaterial beschlägt.

In einer besonders bevorzugten Ausgestaltung der Erfindung ist die Außenelektrode so ausgebildet, dass sie das Endlosmaterial in der Projektion auf seine Querschnittsebene im Wesentlichen vollständig optisch dicht umhüllt. Auf diese Weise ist es möglich eine Form der Gasentladung mit hoher Leistungsdichte zu erzielen. In Kombination mit weiteren Merkmalen der Erfindung, wie weiter unten im Detail erläutert, konnten die Erfinder eine neue Art der Gasentladung realisieren, die sich von den bisherigen Entladungsformen klar unterscheidet und die stufenlose Verstellbarkeit der Plasmabehandlungsdichte von sehr kleinen Werten (ca. 1 W/cm²) bis zu extrem großen Werten (mehrere kW/cm²) ermöglicht, ohne dass die Entladung räumlich oder zeitlich instabil würde.

Durch die solcherart erzielbare extrem hohe Energiedichte an der Endlosmaterialoberfläche, gepaart mit einer kurzen Verweilzeit eines Endlosmaterialabschnittes in der Behandlungszone kann in der Außenschicht des Endlosmaterials eine Temperatur erreicht werden, die wesentlich über der Temperatur im Inneren des Endlosmaterials liegt und somit eine thermisch wesentlich intensivere Behandlung der oberflächennahen Bereiche des Endlosmaterials als der Bereiche im Inneren des Endlosmaterials ermöglicht. Somit werden durch die vorliegende erfindungsgemäße Anlage erstmals die folgenden Anwendungen von Plasmaprozessierung möglich gemacht:
a. Das Prozessieren eines beschichteten Endlosmaterials, wobei die Wirkung auf die Beschichtung groß und die thermische Wirkung auf das Trägermaterial klein ist.
b. Das Schmelzen und dadurch herbeigeführte Verdichten einer elektrolytisch auf das Endlos-Trägermaterial aufgetragenen Beschichtung durch den Plasmaprozess, ohne das Trägermaterial über das gewünschte bzw. tolerierbare Maß hinaus thermisch zu verändern.
c. Das Ingangsetzen eines Diffusionsprozesses um mindestens eine Beschichtung eines Endlos-Trägermaterials durch die Plasmabehandlung, ohne dass der Kern des Trägermaterials über das gewünschte bzw. tolerierbare Maß hinaus thermisch verändert wird. Beispielsweise kann auf das Trägermaterial eine Innenbeschichtung aus Kupfer und eine Außenbeschichtung aus Zink aufgebracht werden, die durch die Plasmaprozessierung zu Messing diffundieren, ohne dass das Trägermateriall über das gewünschte bzw. tolerierbare Maß hinaus thermisch verändert wird.
d. Durch die Plasmabehandlung kann im Außenbereich des Endlosmaterials die Diffusion der Verunreinigungen an die Oberfläche hervorgerufen werden, wobei ) dieser Außenbereich dabei in die flüssige Phase übergehen kann (aber nicht muss). In einem weiteren Plasmabehandlungsschritt kann nach Abkühlung der Außenschicht der äußere Teil dieser Außenschicht, der den Großteil der Verunreinigungen der Außenschicht enthält, ohne große Temperaturerhöhung durch Ionenbeschuss so entfernt werden, dass keine weitere maßgebliche Materialentmischung stattfindet und somit eine besonders verschmutzungsarme Materialzusammensetzung im oberflächennahem Bereich übrigbleibt. Dies ist von besonderem Vorteil, wenn das Endlosmaterial ein Hochfrequenzleiter ist, da im Hochfrequenzbereich die Stromleitung fast ausschließlich im - verschmutzungsarmen - Oberflächenbereich stattfindet.
e. Entfernen eines Martensitüberzugs von einem Endlosmaterial aus Eisen, Nickelbasislegierungen oder dergleichen, der sich aufgrund vorangegangener mechanischer und/oder thermischer Behandlung gebildet hat, mittels Plamabehandlung, ohne dass der Kern des Endlosmaterials über das gewünschte bzw. tolerierbare Maß hinaus thermisch verändert wird. Die Entfernung des 5 Martensitüberzugs kann mittels Plasmabeaufschlagung zur Zerstäubung und/oder Verdampfung und/oder Umwandlung in eine andere Kristallstruktur und/oder Oxidation des Martensitüberzugs führen.
f. Wenn das zu behandelnde Endlosmaterial mit einer Schicht überzogen ist, die während des Glühens entfernt werden soll, wobei diese Schicht insbesondere aus Kohlenstoff (Graphit), Seifen, in besonderen Stearaten, Fetten, Ölen, Emulsionen oder anderen kohlenstoffhaltigen Verbindungen und deren Vermengungen besteht, kann durch Plasmaprozessierung in einer sauerstoffhaltigen Atmosphäre, die bei Entladung die Oxidation dieser Schicht verursacht, diese Schicht wenigstens teilweise entfernt werden. Dabei kann erreicht werden, dass die Oxidationsrückstände in dem Druckbereich der Entladungskammer fast gänzlich oder sogar vollständig gasförmig vorliegen (CO₂ und H₂O) und somit auf dem Endlosmaterial keine oder zumindest fast keine organische oder anderweitig kohlenstoffhaltige oder oxidierbare, vom Endlosmaterial chemisch unterschiedliche, Schicht haften bleibt. Nach dem durch Plasmaprozessierung bewirkten Oxidationsvorgang kann das Endlosmaterial zur Reduktion noch heiß in eine wasserstoffhaltige oder alkoholhaltige oder anders zusammengesetzte reduzierende Gasatmosphäre oder Flüssigkeit eingebracht werden, so dass die bei der Oxidation mitoxidierte Endlosmaterialoerfläche durch geeignete Einstellung der Temperatur des Endlosmaterials und der chemischen Zusammensetzung der Umgebung des Endlosmaterials reduziert (deoxidiert) wird. Diese Reduktion kann alternativ auch in einem weiteren Plasmabehandlungsschritt durchgeführt werden, wobei sowohl die chemische Plasmawirkung als auch die Sputterwirkung als auch deren Kombination zur Deoxidation führen.
g. In der erfindungsgemäßen Anlage kann das Endlosmaterial ohne Zwischenkontaktieren mehrere Plasmabehandlungskammern hintereinander durchlaufen, wobei die chemische Zusammensetzung der Atmosphäre in den einzelnen Plasmabehandlungskammern unterschiedlich sein kann und die Temperatur des Endlosmaterials beim Einlaufen in und Auslaufen aus einzelnen Plasmabehandlungskammern unterschiedlich sein kann.
h. Die erfindungsgemäße Anlage kann so betrieben werden, dass die Temperatur des Endlosmaterials bei der gewählten chemischen Atmosphäre annähernd so gewählt wird, dass eine chemische Reaktion, im Speziellen eine exotherme chemische Reaktion, zwischen der Endlosmaterialoberfläche und der Gasatmosphäre die höchste Reaktionsgeschwindigkeit aufweist. Dies ist ein wesentlicher Fortschritt, da an sich exotherme Reaktionen bei zu hohen Temperaturen langsam oder sogar rückläufig werden, d.h. sie besitzen eine "optimale" Temperatur. Eine wichtige derartige Anwendung ist z.B. die Entgraphitierung von Hochtemperaturdrähten, wobei in einem ersten Schritt das Glühen in sauerstoffhaltiger Atmosphäre erfolgt, wobei Graphit "verbrennt". Wird dieser Prozess bei zu hohen Temperaturen durchgeführt, so kommt man in die Nähe oder sogar über jene Temperatur, bei der der Zerfall von CO₂ bzw. CO der thermodynamisch natürliche Prozess ist, und eine Oxidation von Graphit findet sehr langsam bzw. gar nicht mehr statt. Bei dem erwähnten Prozess wird im Allgemeinen in einem zweiten, separaten Schritt die entstandene Oxydschicht vom Endlosmaterial entfernt. Wird dieser Prozess in Plasma durchgeführt, so unterliegt er im Allgemeinen derselben Problematik.

In einer mechanisch stabilen und fertigungstechnisch günstigen Ausgestaltung der Erfindung definiert die Außenelektrode einen Teil der Entladungskammer und ist vorzugsweise kühlbar, insbesondere flüssigkeitskühlbar.

Um eine allseitig möglichst gleichmäßige Plasmabehandlung des Endlosmaterials zu gewährleisten beträgt in einer Fortbildung der Erfindung das Verhältnis zwischen der Querschnittsfläche innerhalb der Außenelektrode und der Querschnittsfläche der kleinsten konvexen Einhüllenden des Endlosmaterials zumindest 4:1, besser zumindest 10:1, und vorzugsweise zumindest 20:1.

Konstruktionsbedingt kann es vorkommen, dass bei der Anlage zur Plasmaprozessierung das Endlosmaterial in der Behandlungszone nicht in voller Länge vom Längs-Magnetfeld umhüllt wird, was potentiell das Auftreten von Bogenentladungen begünstigt. Um auch an solchen Stellen der Behandlungszone dennoch das Auftreten von Bogenentladungen zu unterdrücken ist in einer Fortbildung der Erfindung vorgesehen, dass die Einrichtung zur Einstellung einer Gasatmosphäre in der wenigstens einen Entladungskammer dazu ausgebildet ist, in Bereichen der Gasentladungskammer, in denen das Längs-Magnetfeld das Endlosmaterial unvollständig bzw. mit reduzierter magnetischer Feldstärke umhüllt, eine Gasströmung mit einer Strömungsgeschwindigkeitskomponente in Längsrichtung des Endlosmaterials zu erzeugen. Auf diese Weise wird verhindert, dass sich Gasteilchen zu lange in diesen Bereichen der Gasentladungskammer auffalten.

Ein wesentlicher Zusatznutzen aus der Magnetbeeinflussung der Entladung kommt der Endlosmaterialbehandlung ebenso zugute: Nicht nur, dass die Entladung, falls die Außenelektrode noch im starken Magnetfeld in ihrer Ausdehnung abgegrenzt ist, bis zu sehr hohen Leistungen nur im Magnetfeld brennt, steigt mit zunehmendem Magnetfeld auch die makroskopische Leitfähigkeit des Plasmas in einem Maß, das ein wirksames Werkzeug zur räumlichen Einprägung der Entladung oder zumindest des Entladungsschwerpunktes in der Längsrichtung des Endlosmaterials darstellt. Dieses Werkzeug kann bei entsprechender Parameterwahl oft eine gleichmäßige Behandlung eines Endlosmaterials gewährleisten, die sonst unmöglich wäre, weil das Endlosmaterial in der Behandlung sehr stark zur Bildung von überhitzten Teilbereichen neigt, die für kurze Zeit den Entladungsschwerpunkt mit der Vorwärtsbewegung des Endlosmaterials mitziehen.

Mit der vorliegenden Erfindung ist erstmals eine gleichmäßige Plasmabearbeitung von (ungleichmäßig) verschmutzten Endlosmaterialien möglich:
Die inhärente Stromquelle prägt den Entladungsstrom ein, so das er sich (im Gegensatz zum Stand der Technik) mit der Bewegung des Endlosmaterials nicht ändern kann (trotz der Gaszusammensetzungsschwankungen und trotzt der unterschiedlichen Sekundärelektronenemissivität, also trotz schneller und großer Änderungen der Entladungsbedingungen), und das Magnetfeld prägt den genauen Ort der Entladung ein, so dass der Entladungsschwerpunkt (im Gegensatz zum Stand der Technik) stehen bleibt und jeden Drahtabschnitt gleich lange beschlägt. Die Kombination dieser zwei Werkzeuge stellt eine Steigerung der Leistungsfähigkeit der Anlage dar, die weit größer ist als deren einfache Summe und ist einer der wesentlichen Kernpunkte der Erfindung.

Die Pulsung der Leistung, die konstante Stromabgabeeigenschaft der inhärenten Stromquelle, das Magnetfeld und ggf. ein starker Gasstrom unterstützen sich gegenseitig im Unterdrücken des Überganges der neuen Entladungsform in eine klassische Bogenentladung, so das eine bis dato unerreichbare Plasmaleistungsdichte flächendeckend gleichmäßig über die Endlosmaterialoberfläche prozessierbar ist.

In einer Ausgestaltung der Erfindung ist der Druck in der Entladungskainmer auf 0,1 bis 100 mbar, bevorzugter auf 0,5 bis 50 mbar, am bevorzugtesten auf 1 bis 10 mbar eingestellt. Dieser Druckbereich ist niedrig genug, um eine flächige Beschlagung des Endlosmaterials mit Plasma zu ermöglichen, und gleichzeitig hoch genug, damit eine ausreichend große Anzahl von Teilchen in der Entladungskammer vorhanden sind, die für die erwünscht hohen elektrischen Ströme bei der Plasmaprozessierung hinreichend sind. Der Druck in der Entladungskammer ist weiters hoch genug, um das Vakuum-, Gasversorgungs- und Schleusensystem einfach und effizient zu halten.

Bei der erfindungsgemäßen Anlage zur Plasmaprozessierung umfasst die Einrichtung zur Einstellung einer Gasatmosphäre bevorzugt ein Vorkammern- und/oder ein Nachkammernsystem, wobei zwischen den Kammern dieser Systeme Schleusenöffnungen vorgesehen sind, durch welche das Endlosmaterial hindurchführbar ist. Es hat sich zur Erzielung einer guten Schleusenwirkung als äußerst wirksam herausgestellt, wenn zumindest eine Schleusenöffnung als Tunnel ausgebildet ist, der vorzugsweise ein Verhältnis zwischen Tunnellänge zu lichter Weite des Tunnels von zumindest 2: 1, bevorzugt zumindest 4:1, aufweist. Bevorzugt sind dabei zumindest jene Schleusen als Tunnels ausgebildet, bei denen auf beiden Seiten Unterdruck bei unterschiedlichen Gaszusammensetzungen herrscht und an der Schleusenöffnungsseite mit dem höheren Druck eine Gasvermischung vermieden werden soll. Dies ist z.B. zwischen Prozesskammern mit unterschiedlichen Prozessgasen der Fall.

Um besonders gassparend die Plasmaprozessierung durchzuführen, was insbesondere bei teuren Prozessgasen, wie z.B. Helium, von Bedeutung ist, ist in Weiterbildung der Erfindung vorgesehen, dass die Einrichtung zur Einstellung einer Gasatmosphäre ein Rückgewinnungssystem umfasst, bei dem Gas aus einer Nachkammer in eine Vorkammer und/oder Nachkammer mit höherem Druckniveau umwälzbar ist.

Eine weitere vorteilhafte Ausgestaltung der Erfindung zeichnet sich dadurch aus, dass die Vorkammern in Unterkammern unterteilt sind und/oder das Nachkammmernsystem aus einzelnen Nachkammern zusammengesetzt ist, wobei zwischen den Unterkammern bzw. den Nachkammern Schleusenöffnungen vorgesehen sind, durch welche das Endlosmaterial durch die Unterkammern bzw. die Nachkammern hindurch führbar ist. Die Ausbildung von Unterkammern und Nachkammern ermöglicht eine sichere und wirtschaftliche Aufrechterhaltung der gewünschten Atmosphäre in der Entladungskammer und verhindert das unerwünschte Eintreten von Luft in die Entladungskammer.

Die Erfindung wird nun unter Bezugnahme auf die beiliegenden Zeichnungen anhand von nicht einschränkenden Ausführungsbeispielen näher erläutert.
Fig. 1 zeigt einen schematischen Längsschnitt durch eine erfindungsgemäße Anlage zur Plasmaprozessierung eines Endlosmaterials.
Fig. 2 zeigt einen schematischen Längsschnitt durch eine alternative Ausführungsform einer erfindungsgemäßen Anlage zur Plasmaprozessierung eines Endlosmaterials.
Fig. 3 zeigt ein Blockschaltbild einer erfindungsgemäßen Energieversorgungseinrichtung.
Fig. 4 zeigt einen typischen Spannungs-, Strom- und Leistungsverlauf eines Niederdruckplasmas mit Glimmcharakteristik, wenn die Entladungsstrecke an eine gepulste Spannungsquelle nach dem Stand der Technik angeschlossen ist.
Fig. 5 zeigt einen typischen Spannungs-, Strom- und Leistungsverlauf eines Niederdruckplasmas mit Glimmcharakteristik, wenn die Entladungsstrecke an eine inhärente Stromquelle gemäß der Erfindung angeschlossen ist.
Fig. 6 zeigt einen typischen Spannungs-, Strom- und Leistungsverlauf des Auftretens einer Bogenentladung, wenn die Entladungsstrecke an eine gepulste Spannungsquelle nach dem Stand der Technik angeschlossen ist, und die Reaktion des Bogenunterdrückungsmechanismus, ohne den ein unkontrollierter, lawinenartiger Stromanstieg zur Zerstörung von Bauteilen führen würde.
Fig. 7 zeigt einen typischen Spannungs-, Strom- und Leistungsverlauf einer Bogenentladung, wenn die Entladungsstrecke an eine inhärente Stromquelle mit nicht vorhandenem oder nicht aktiviertem Bogenunterdrückungsmechanismus gemäß der Erfindung angeschlossen ist.
Fig. 8 zeigt ein Blockschaltbild einer erfindungsgemäßen Plasmaprozessierungsanlage mit mehreren Behandlungseinheiten.
Fig. 9 zeigt im Längsschnitt eine als Tunnel ausgebildete Schleusenöffnung.
Fig. 10 zeigt einen Längsschnitt durch eine weitere Ausführungsform einer Anlage zur Plasmaprozessierung von Endlosmaterial.
Fig. 11 zeigt eine Ausführungsform einer Außenelektrode in Seitenansicht.
Fig. 12 zeigt eine weitere Ausführungsform einer Außenelektrode im Querschnitt.
Fig. 13 zeigt einen Längsschnitt durch wiederum eine andere Ausführungsform einer Anlage zur Plasmaprozessierung von Endlosmaterial.
Fig. 14 zeigt die Anlage von Fig. 1 mit verringertem Abstand der Magnete voneinander.

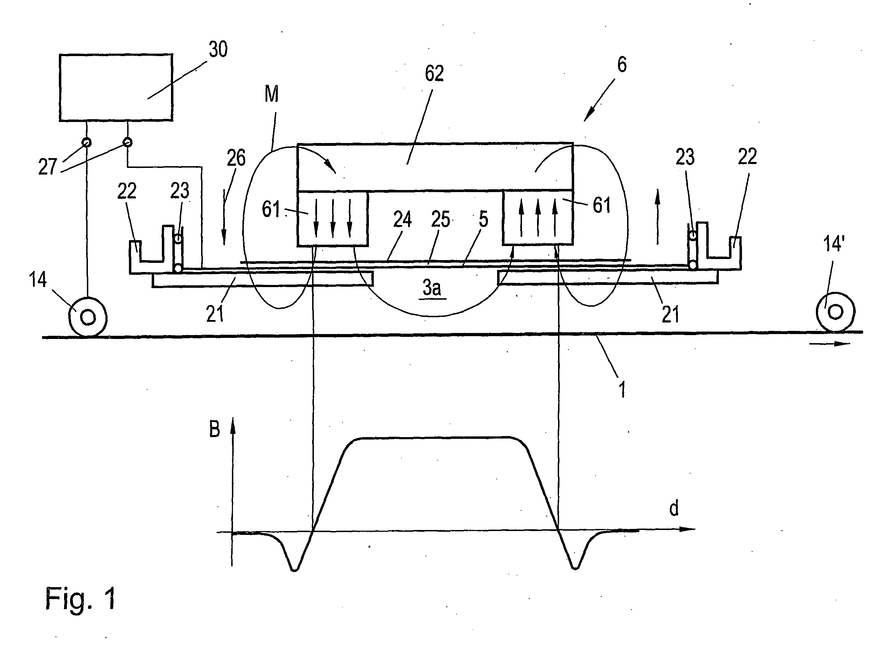

Fig. 1 zeigt einen schematischen Längsschnitt durch eine erfindungsgemäße Anlage zur Plasmaprozessierung eines Endlosmaterials 1, wobei die Anlage zumindest eine evakuierbare rohrförmige Entladungskammer 3a aufweist. Das Endlosmaterial 1 wird kontinuierlich durch die Entladungskammer 3a hindurch transportiert, wobei das Endlosmaterial nur außerhalb der Endladungskammer 3a durch Rollen 14, 14' geführt wird, innerhalb der Endladungskammer 3a aber nicht kontaktiert wird. Die Entladungskammer 3a weist eine Außenelektrode 5 auf, die in Bezug auf das Endlosmaterial 1 elektrisch isoliert angeordnet ist. Im vorliegenden Ausführungsbeispiel ist die Außenelektrode 5 rohrförmig ausgebildet und wird an ihren Enden von rohrförmigen, voneinander beabstandeten Isolierkörpern 21, 21 aus Glas, Keramik oder dergleichen gehalten, so dass die Isolierkörper 21, 21 ein "Fenster" bilden, das von der Außenelektrode 5 eingenommen wird. Die Isolierkörper 21, 21 werden von Flanschen 22, 22 in Position gehalten. O-Ringe 23 dichten zwischen Außenelektroden 5 und den Flanschen 22, 22. Die Außenelektrode 5 ist weiters von einem Kühlrohr 24 umgeben, wobei zwischen der Außenelektrode 5 und dem Kühlrohr 24 ein Hohlraum 25 definiert ist, der von einem Kühlmedium 26 durchflossen wird. In der Entladungskammer 3a wird durch eine nicht dargestellte Einrichtung zur Einstellung einer Gasatmosphäre eine gewünschte Gasatmosphäre und der gewünschte Druck eingestellt. Zwischen der Außenelektrode 5 der Entladungskammer 3a und dem Endlosmaterial 1 als Innenelektrode ist eine Entladungsstrecke G definiert. Damit es an der Entladungsstrecke G zur Gasentladung kommen kann, ist über einen Anschluss 27 eine Energieversorgungseinrichtung 30 zur Abgabe von elektrischer Entladungsenergie an das Endlosmaterial 1 und die Außenelektrode 5 angeschlossen. Im vorliegenden Ausführungsbeispiel erfolgt der elektrische Anschluss des Endlosmaterials 1 an die Energieversorgungseinrichtung 30 über die aus elektrisch leitfähigem Material ausgebildete Führungsrolle 14. Die Entladungskammer 3a ist weiters von einer Permanentmagnetanordung 6 umgeben, die Permanentmagnete 61 aufweist, die in Längsrichtung des Endlosmaterials 1 gesehen voneinander beabstandet und in umgekehrter Magnetisierung mit einem Eisenschlusselement 62 verbunden sind. Das Eisenschlusselement 62 konzentriert das Magnetfeld der Permanentmagnetanordnung 6 im Bereich der Gasentladungsstrecke. Der sich dadurch ergebende Verlauf der magnetischen Feldlinien M ist in Fig. 1 eingezeichnet. Baueinheiten, bestehend aus einem Eisenschlusselement 62 und Permanentmagneten 61 umgeben die Entladungskammer 3a in Form eines Prismas mit polygonartigem (z.B. sechseckigem) Querschnitt, wie in dem Dokument WO 2004/073009 A2 dargestellt, das hiermit durch Verweis aufgenommen ist. Aus Gründen der besseren Übersichtlichkeit ist in Fig. 1 nur eine solche Baueinheit dargestellt. Die Permanentmagnete 61 sind vorzugsweise aus einem anisotropen Material hergestellt, weisen also eine Vorzugsrichtung auf, und sind im Wesentlichen radial in Bezug auf den Querschnitt des Prismas polarisiert. Anisotrope Permanentmagnete 61 können sehr stark magnetisiert werden. Insbesondere Permanentmagnete 61 aus einer NdFeB-Legierung sind sehr gut geeignet. Der Verlauf der magnetischen Flussdichte B in der Entladungskammer 3a über der Länge d zeigt, dass im Bereich der Magnete 61, 61 jeweils Nulldurchgänge der magnetischen Flussdichte B auftreten, wogegen im Bereich zwischen den Magneten 61, 61 die magnetische Flussdichte B weitgehend konstant ist. Außerhalb der Magnete 61, 61 treten deutliche negative Maxima der magnetischen Flussdichte B auf. Somit wird durch diesen Aufbau der Magnetanordnung ein über den Verlauf seiner Längsausdehnung inhomogenes Magnetfeld erzeugt, dessen Maxima die Maxima der Behandlungsintensität des Endlosmaterials festlegen. Im vorliegenden Ausführungsbeispiel ragt der für die Gasentladung wirksame Teil der Außenelektrode 5 in Längserstreckung nicht aus dem Magnetfeld heraus, wodurch ein "Hinausbrennen" der Entladung aus dem Magnetfeld unterdrückt wird.

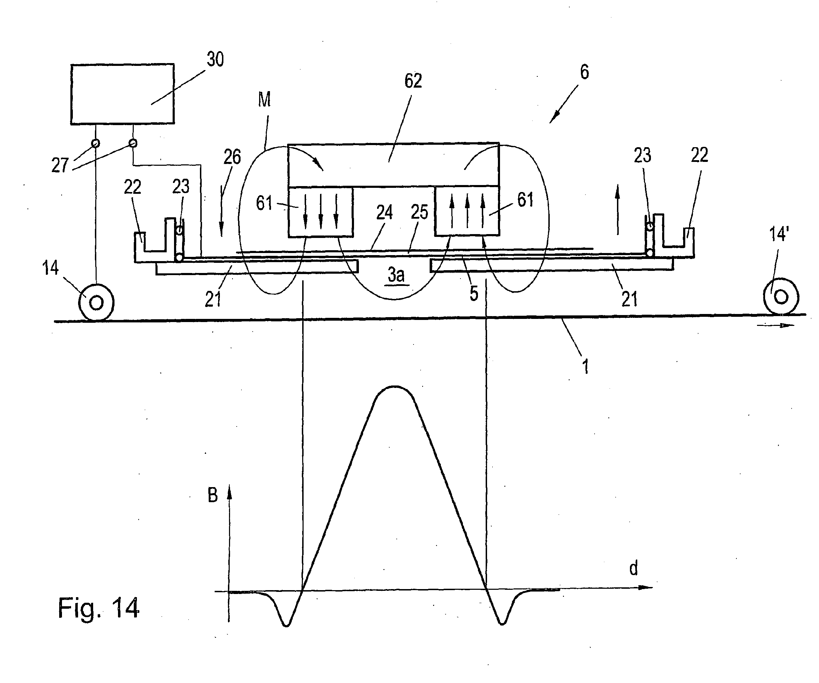

Fig. 14 zeigt eine Variante der Anlage gemäß Fig. 1 mit verringertem Abstand der Permanentmagnete 61 voneinander. Aufgrund dieses verringerten Abstandes ergibt sich ein anderer Verlauf der magnetischen Flussdichte B, die nunmehr in der Mitte der Entladungsstrecke ein ausgeprägtes Maximum anstelle eines konstanten Verlaufs aufweist. Durch dieses ausgeprägte Maximum findet eine eindeutige Lagefixierung der Entladung an dieser Stelle statt.

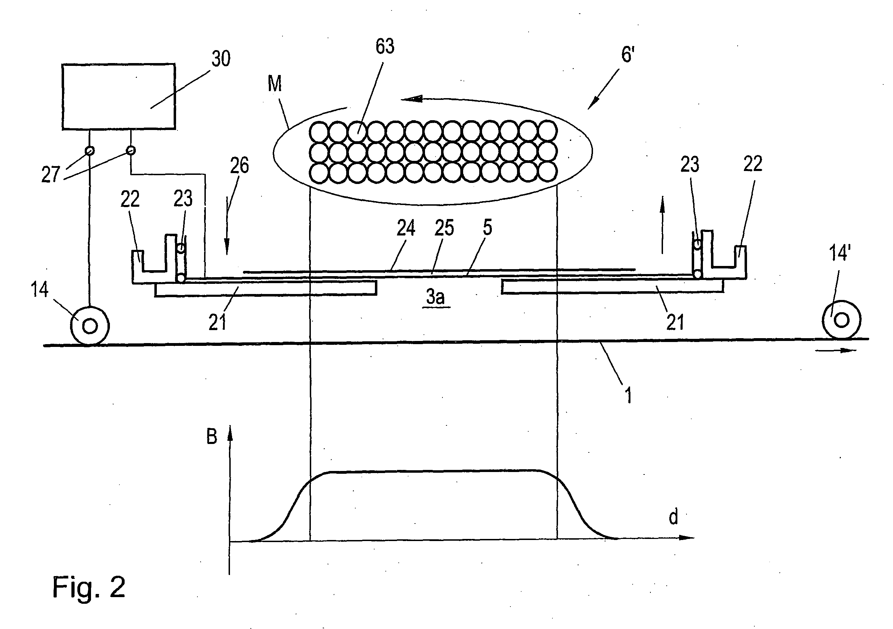

In Fig. 2 ist im schematischen Längsschnitt eine alternative Ausführungsform der erfindungsgemäßen Anlage zur Plasmaprozessierung dargestellt. Diese Ausführungsform unterscheidet sich von der ersten Ausführungsform insofern, als die Magnetanordnung keine Permanentmagnetanordnung, sondern eine Elektromagnetanordnung 6' ist, die eine die Außenelektrode 5 umgebende Spule 63 aufweist, die im Wesentlichen koaxial mit dem Endlosmaterial 1 angeordnet ist, wobei die Spule vorzugsweise als gekühlte, insbesondere flüssigkeitsgekühlte, Spule, optional als supraleitender Elektromagnet, ausgebildet ist. Der Verlauf der magnetischen Feldlinien M zeigt, dass sich im Inneren der Spule 63 ein weitgehend homogenes Magnetfeld einstellt, wie im Diagramm anhand des Verlaufs der magnetischen Flussdichte B in der Entladungskammer 3a über der Länge d deutlich zu sehen.

Die Magnetanordnung sowohl der Ausführungsform nach Fig. 1 als auch der Ausführungsform nach Fig. 2 ist als Hochleistungsmagnetanordnung ausgebildet, die im Bereich der Außenelektrode 5 ein starkes, im wesentlichen parallel mit dem Endlosmaterial ausgerichtetes Magnetfeld von zumindest 120 mT, vorzugsweise von zumindest 400 mT, am bevorzugtesten von zumindest 700 mT, erzeugt. Zur Reinigung von stark verschmutztem Material mittels Plasmaprozessierung können auch Magnetfelder von bis zu 1,5 T erzeugt werden.

Erfindungsgemäß ist die Energieversorgungseinrichtung 30 als eine zur pulsförmigen Abgabe der Entladungsenergie ausgebildete inhärente Stromquelle konstruiert, die zumindest eine Induktivität als Energiespeicher aufweist, die mit einer ihr zugeordneten Entladungsstrecke G oder sukzessive mit mehreren ihr zugeordneten Entladungsstrecken G zusammenschaltbar ist.

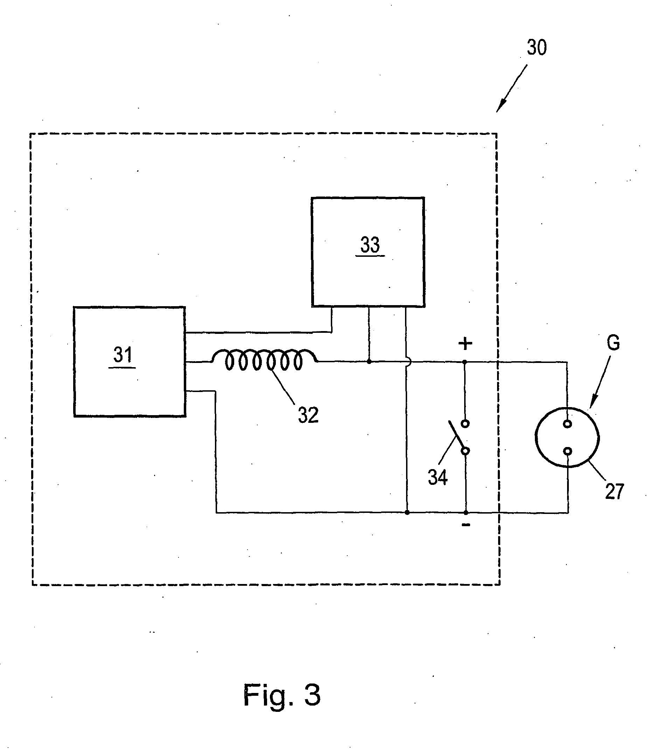

Ein möglicher Aufbau der prinzipiellen Schaltungstopologie der Energieversorgungseinrichtung 30 wird am folgenden Beispiel unter Bezugnahme auf Fig. 3 erläutert. Die Energieversorgungseinrichtung 30 weist einen Energieversorgungskreis 31 auf, der bei Bedarf elektrische Energie in eine Induktivität 32 einspeist, die als Energiespeicher dient. Die Induktivität 32 ist über den Anschluss 27 in Serie mit der Entladungsstrecke G geschaltet, so dass die Induktivität 32 die gespeicherte Energie an die Entladungsstrecke G abgeben kann. Der geregelte Energieversorgungskreis 31 lädt dabei die Induktivität 32 so mit Energie auf, dass der von der Induktivität 32 an die Entladungsstrecke G abgegebene elektrische Strom näherungsweise konstant gehalten wird. Die Energieversorgungseinrichtung 30 umfasst weiters einen Pulspausenschalter 34, der parallel zur Entladungsstrecke G liegt. Zur Pulsung (Erzeugung einer Pulspause) des von der Induktivität an die Entladungsstrecke G abgegebenen elektrischen Stroms wird die Entladungsstrecke G mittels des Pulspausenschalters 34 vorübergehend kurzgeschlossen, sodass der Strom zwar weiter durch die Induktivität 32 fließt, nicht jedoch über die Entladungsstrecke G, sondern durch den Pulspausenschalter 34. Des weiteren ist es sinnvoll, dafür zu sorgen, dass der Spannungsmaximalwert an der Entladungsstrecke G begrenzt wird, da die Impedanz des Plasmas in der Entladungsstrecke G am Pulsanfang sehr hoch sein kann und beim Öffnen des Pulspausenschalters 34 der konstante Strom aus der Induktivität 32 ansonsten einen unkontrollierten und sowohl für den Plasmaprozess wie auch für die Anlage und deren Umgebung gefährlichen Spannungsanstieg bewirken könnte. Diese Aufgabe übernimmt der Spannungsbegrenzungskreis 33, der in der Anfangsphase des Pulses, wenn die maximal zugelassene Spannung an der Entladungsstrecke G erreicht worden ist, aber der Strom durch die Entladungsstrecke G noch nicht dem durch die Induktivität 32 fließenden Strom entspricht, die Spannung begrenzt und so zwangsweise einen gewissen Betrag der Energie der Induktivität abzweigt. Dieser Spannungsbegrenzungskreis 33 kann auf unterschiedliche Art realisiert werden, wobei er entweder die von der Induktivität abgezweigte Energie vernichten, d.h. in Wärme umwandeln, oder aber auch speichern und weiterverwerten bzw. zur Weiterverwertung frei geben kann.

Zwischen der Induktivität 32 der Energieversorgungseinrichtung 30 und der zumindest einen Entladungsstrecke kann weiters eine Entzerrschaltung angeordnet sein, um die parasitären Hochfrequenzeffekte bzw. deren Einflüsse, wie z. B. die Induktivität der Stromleiter, die Kapazität der Entladungskammer bzw. der Elektroden u. Ä. zu unterdrücken bzw. zu kompensieren. Diese Entzerrschaltung kann in den Spannungsbegrenzungskreis 33 integriert sein.

Neben der in Fig. 3 dargestellten Ausführungsform der erfindungsgemäßen Energieversorgungseinrichtung gibt es alternative Möglichkeiten, eine inhärente Stromquelle zu realisieren. So kann beispielsweise die Energiespeicherspule auch Teil eines Transformators sein, wobei die Energieeinbringung über eine weitere, mit der Energiespeicherspule magnetisch gekoppelte Transformatorwicklung erfolgt. Eine weitere Wicklung kann zur Diagnostik vorgesehen sein.

Für das Wesen der erfindungsgemäßen Energieversorgungseinrichtung wichtig ist eine verlustfreie bzw. möglichst verlustarme Koppelung einer stromdurchflossenen Induktivität als Energiespeicher mit den beiden Elektroden der Entladungsstrecke G, kombiniert mit Mitteln zur Erzeugung von Pulsen, wie dem in Fig. 3 dargestellten Pulspausenschalter 34. Es sei jedoch erwähnt, dass die Mittel zur Erzeugung von Pulsen auch anders ausgeführt werden können, beispielsweise als Schalternetzwerk, mit dem auch eine Umkehrung der Pulspolarität durchführbar ist.

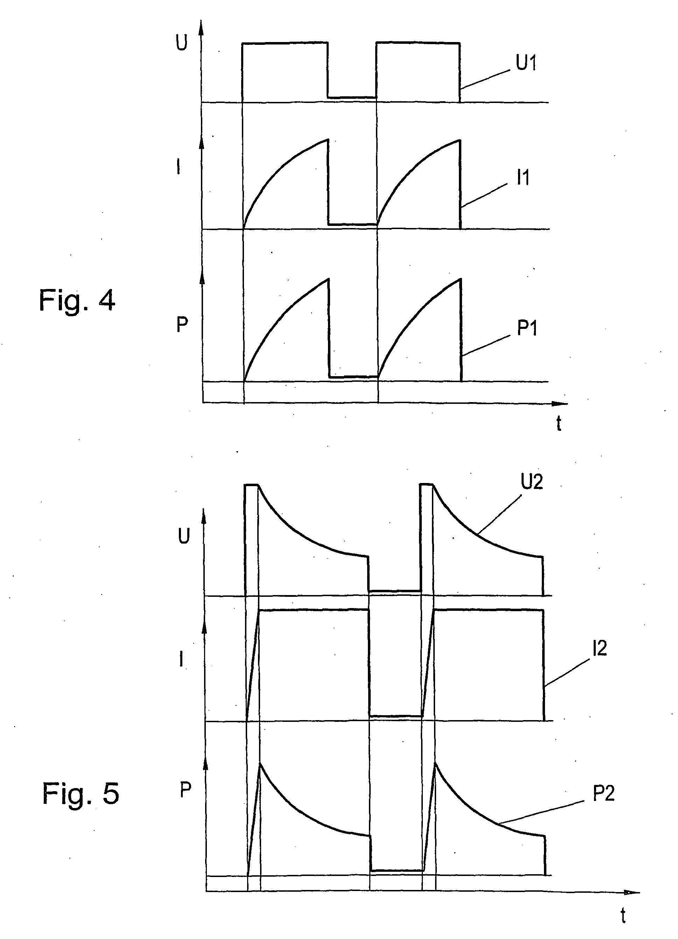

Zur Erläuterung der vorteilhaften Wirkung der erfindungsgemäßen gepulsten inhärenten Stromquelle wird zunächst auf die in Fig. 4 dargestellten Verläufe von Strom I1, Spannung U1 und elektrischer Leistung P1 verwiesen, die sich an der Entladungsstrecke G bei Niederdruckplasma mit Glimmcharakteristik einstellen, wenn die Entladungsstrecke G an eine gepulste Spannungsquelle nach dem Stand der Technik angeschlossen ist. Man sieht, dass bei jedem Puls die Spannung U1 konstant ist und der elektrische Strom I1 und die Leistung P1 mit der Zeit anwachsen, ein sehr ungünstiger Verlauf, der das Umschlagen von der Glimmentladung in eine Bogenentladung mit Fortdauer des Pulses immer wahrscheinlicher macht.

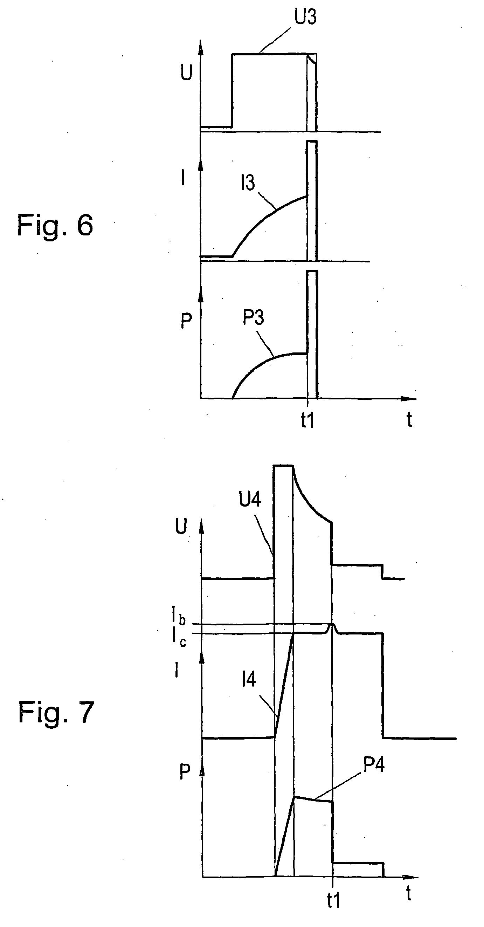

Im Gegensatz dazu wird bei erfindungsgemäßer Ausbildung der Energieversorgungseinrichtung als gepulste inhärente Stromquelle ein Verlauf von Strom I2, Spannung U2 und elektrischer Leistung P2 erreicht, der das Auftreten einer Bogenentladung äußerst unwahrscheinlich macht, wie in Fig. 5 für eine Entladungsstrecke, an der ein Niederdruckplasma mit Glimmcharakteristik herrscht, zu sehen. Man sieht aus diesem Diagramm, dass die Spannung U2 und die Leistung P2 während der Pulsdauer, abgesehen von der kurzen Zeit am Pulsanfang, wenn der konstante Wert des Stroms I2 noch nicht erreicht ist, abfallen. Dieses Verhalten kann man als Zeitreziprozität bezeichnen. Damit wird bei sonst unveränderten Verhältnissen der Entladungsanordnung und Parametrisierung durch die erfindungsgemäße Maßnahme eine gegenüber den Spannungsquellen nach dem Stand der Technik wesentlich größere, typischerweise doppelte bis zwanzigfache Leistungseinkopplung in die Entladungsstrecke G möglich, ohne dass die Plasmacharakteristik von einer Glimm- oder glimmähnlichen (das Endlosmaterial flächig beschlagenden) Charakteristik in eine Bogenentladung umschlägt. Des weiteren ist bei Verwendung der inhärenten Stromquelle auch das Auftreten eines Entladungsbogens wesentlich weniger kritisch, da im Falle seines Auftretens die Entladungsenergie nicht (oder kaum, da betragsmäßig und zeitlich sehr begrenzt) steigt, wie in den Diagrammen von Fig. 7 anhand der Verläufe von Strom I4, Spannung U4 und Leistung P4 dargestellt, wobei der Entladungsbogen zum Zeitpunkt t1 auftritt. Vielmehr sinkt die Leistung P4 und damit die Entladungsenergie sogar stark ab, da die Ausbildung des Bogens elektrisch eine Impedanzverringerung darstellt. Somit ist es möglich, dass die Bogenentladung von allein wieder verlöscht. Falls man jedoch durch eine entsprechende Regelung eingreift, indem man bei Detektieren der Bogenentladung die weitere Energieeinbringung in das Plasma unterbindet, z.B. indem man das Plasma kurzschließt, wird die nötige Eingriffszeit gegenüber dem Stand der Technik wesentlich verkürzt. Entladungsstabilisierend kommt im Falle der Realisierung der Pulspause mittels Kurzschließens des Plasmas noch der Umstand dazu, dass aufgrund dieses Kurzschlusses über die Entladungsstrecke die Ladungsträger in der Entladung über die Elektroden abfließen können, was die nötige Pulspausenzeit nochmals verkürzt.

Es sei erwähnt, dass es in der Realität vorkommt, dass zwischen den Elektroden der Entladungsstrecke Kapazitäten auftreten. Diese können parasitärer Natur sein oder aber kleine Kondensatoren, die man zur Stabilisierung und Entzerrung von Halbleiterbauelementen und Schaltelementen verwendet. Diese Kapazitäten bewirken einen vorübergehenden Anstieg des Stroms I4 von seinem Konstantwert I_{c} auf einen Spitzenwert I_{b}. Im Allgemeinen können jedoch die Auswirkungen dieser Kapazitäten und des dadurch hervorgerufenen, im Vergleich mit der Pulsdauer kurzzeitigen Stromanstieges vernachlässigt werden.

Im Gegensatz zur Verwendung einer inhärenten, gepulsten Stromquelle als Energieversorgung, wie gemäß der Erfindung vorgeschlagen, tritt bei Versorgung der Entladungsstrecke durch eine Spannungsquelle eine massive Erhöhung der eingekoppelten Leistung auf, wenn eine Glimmentladung in eine Bogenentladung umschlägt. Dies ist anhand der Verläufe von Strom I3, Spannung U3 und Leistung P3 aus dem Diagramm von Fig. 6 deutlich zu erkennen und würde ohne Eingriff des Bogenunterdrückungsmechanismus zur Zerstörung von zumindest dem stromempfindlichsten Element im Stromkreis führen.

Auch die oben erläuterte Problematik der sehr schnellen Impedanzänderung des Plasmas aufgrund von Gaszusammensetzunkschwankungen oder Oberflächenschwankungen (Sekundärelektronenemission) wird durch die erfindungsgemäße inhärente, gepulste Konstantstromquelle sehr stark entschärft. Im Falle von Impedanzerhöhung der Entladung durch Verunreinigungen im Entladungsgas wird durch den resultierenden Spannungsanstieg an der Entladungsstrecke der Entladung prompt mehr Energie zur Verfügung gestellt. Mit dieser Zusatzenergie werden die Verunreinigungsmoleküle zerschlagen oder andere plasmahemmende Einflüsse (z. B. Einfangen von Elektronen) gesättigt. Dieses vorteilhafte Verhalten ermöglicht die technische Realisierbarkeit von Plasmaprozessen, die mit Mitteln des Standes der Technik nicht durchführbar waren. So führt beispielsweise bei Plasmaanlagen nach dem Stand der Technik das Berühren eines zu behandelnden Drahts mit bloßen Fingern unmittelbar vor der Plasmabehandlung oft zu einem Zusammenbruch der Entladungsstabilität mit sehr vielen Übergängen zu schwer zu stoppenden Bogenentladungen. Das Chlor im Salz an der Haut ist für die Prozessunterbrechung verantwortlich, die unabhängig von der Prozessleistung auftritt. Wird dem Plasma jedoch gemäß der Erfindung Energie von einer inhärenten Stromquelle zugeführt, so ändert sich nur die Farbe der Entladung selbst, ein Umschlagen in Bogenentladung kann jedoch nicht beobachtet werden; auch die Behandlungsintensität an der betroffenen Drahtstelle unterscheidet sich nur gering von jener an unbetroffenen Stellen.

Eine Behandlung eines Endlosmaterials mit mehr als zwei hintereinander angeordneten Behandlungseinheiten (Elektroden), bei dem die Erdung oder Kontaktierung des Endlosmaterials zwischen den Behandlungseinheiten aus technischen.Gründen nicht möglich ist (entweder weil die Temperatur des Endlosmaterials zu hoch ist oder aber um eine Beeinträchtigung der Oberflächenstruktur, Textur oder Reinheit zu vermeiden) wird im Allgemeinen erst durch die Verwendung von inhärenten Stromquellen möglich gemacht, insbesondere, wenn nicht an allen Elektroden immer nur gleichgepolte Energiepulse angelegt werden. Es sei erwähnt, dass Plasmaprozessierungsanwendungen, die eine sehr hohe Behandlungstemperatur (über ca. 1000-1500 Grad Celsius, je nach Material) des Endlosmaterials erfordern, nur durch mehr als zwei hintereinander geschaltete Elektroden bzw. Entladungskammern realisiert werden können. Bei Einsatz der inhärenten Stromquelle ist die elektrische Leistung, die in die Erwärmung des zu behandelnden Endlosmaterials umgesetzt wird, weitestgehend von Potentialschwankungen des Endlosmaterials unabhängig, da der gewünschte Strom auf jeden Fall eingeleitet wird. Zwischen den einzelnen Elektroden bzw. Entladungskammern können zwar Potentialverschiebungen und -schwankungen auftreten, deren Größen nicht exakt bekannt sind, da aber die Potenzialschwankung an einem beliebigen Punkt des Endlosmaterials in der Praxis unter 10 % der Plasmabrennspannung liegt, ist der Fehler bei der Leistungsbestimmung an einer einzelnen Elektrode ebenso maximal 10%.

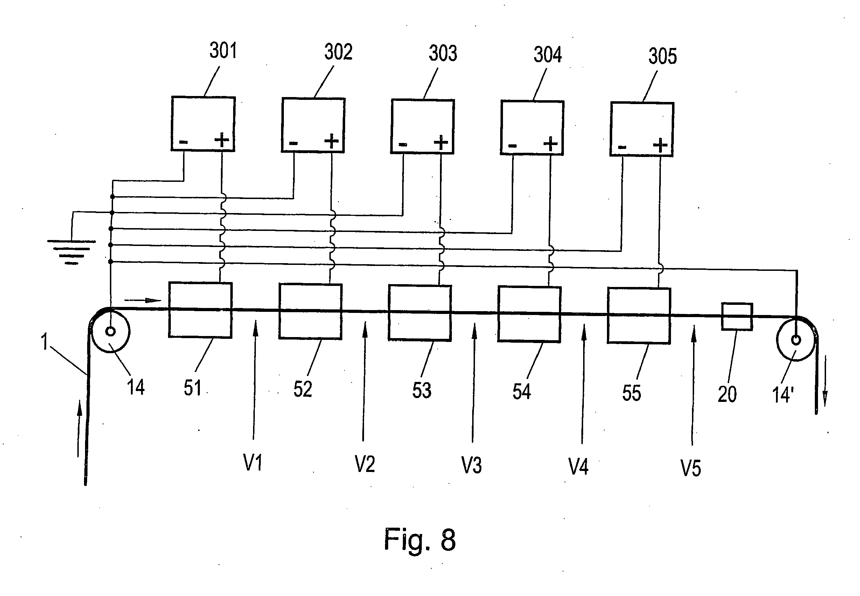

Fig. 8 stellt ein schematisches Blockschaltbild einer Hintereinanderschaltung von fünf Behandlungseinheiten dar. Die Bezugszeichen 51, 52, 53, 54, 55 bezeichnen die Elektroden der jeweiligen Behandlungseinheiten, Bezugszeichen 301, 302, 303, 304, 305 bezeichnen die als inhärente gepulste Stromquellen ausgebildeten Energieversorgungseinrichtungen, wobei ein erster Anschluss der jeweiligen Energieversorgungsreinrichtung 301 - 305 geerdet ist und ein zweiter Anschluss mit der jeweiligen Elektrode 51 - 55 verbunden ist. Das Endlosmaterial 1 wird in Pfeilrichtung von den geerdeten Führungsrollen 14, 14' gestützt durch die Behandlungseinheiten hindurchgeführt. Die Führungsrollen 14, 14' sind vor bzw. hinter den Behandlungseinheiten angeordnet und erden das Endlosmaterial 1 an den Berührungsstellen. Bezugszeichen V1, V2, V3, V4, V5 stellen Potentialpunkte zwischen bzw. nach den Behandlungseinheiten dar, wobei nur die Potentialpunkte V1 und V5 als geerdet angesehen werden können, die Potentialpunkte V2, V3, V4 jedoch in unbekanntem Maß vom Erdpotential abweichen. Wie oben erwähnt, sind zusätzliche Kontaktierungen des Endlosmaterials zwischen den Behandlungseinheiten nicht möglich, da, insbesondere bei Hochtemperaturanwendungen, das Endlosmaterial 1 dadurch beschädigt würde. Nach der Elektrode 55 ist eine Kühleinheit 20 angeordnet, in der das Endlosmaterial 1 so weit abgekühlt wird, dass es ohne Beschädigung mit der nachgeordneten Führungsrolle 14' sowie mit Umgebungsluft in Berührung kommen darf.

Anstelle der Versorgung der fünf Elektroden 51-55 mit fünf Energieversorgungseinrichtungen kann auch eine einzige erfindungsgemäße Stromquelle verwendet werden, die sukzessive an alle Elektroden 51-55 geschaltet wird und Konstantstrompulse, vorzugsweise jeweils mit einem sehr kurzem Tastverhältnis, an die Elektroden abgibt. Die Konstantstrompulse können von Elektrode zu Elektrode in ihrer Pulsdauer und Polarität variieren, wobei eine Leistungsbestimmung über die Pulsbreiten für jede Elektrode separat möglich ist. Ein solcher Betrieb einer Plasmaprozessierungsanlage ist mit einer klassischen Spannungsquelle unmöglich.

Wie oben erwähnt, ist bei den Ausführungsformen der erfindungsgemäßen Anlage zur Plasmaprozessierung gemäß den Figuren 1 und 2 eine Hochleistungsmagnetanordnung vorgesehen, die im Bereich der Außenelektrode 5 ein starkes, im wesentlichen parallel mit dem Endlosmaterial 1 ausgerichtetes Magnetfeld von zumindest 120 mT, vorzugsweise von zumindest 400 mT, am bevorzugtesten von zumindest 700 mT, erzeugt. Es ist zwar prinzipiell bereits bekannt, elektrische Entladungen mit Magnetfeldern zu beeinflussen, jedoch können in Zusammenhang mit geeigneten Drücken in den Entladungskammern, neuartigen Konstruktionen zur Einstellung und Aufrechterhaltung dieser Drücke in der Anlage zur Plasmaprozessierung, speziellen Ausgestaltungen der Elektroden sowie unter Anwendung der inhärenten Stromquelle Entladungsformen realisiert werden, die nach dem Stand der Technik nicht realisierbar waren.

Bei der erfindungsgemäßen Anlage zur Plasmaprozessierung ist aus nachfolgenden Gründen vorgesehen, den Druck in der Entladungskammer auf 0,1 bis 100 mbar, bevorzugter auf 0,5 bis 50 mbar, am bevorzugtesten auf 1 bis 10 mbar einzustellen.

Bei Atmosphärendruck und ähnlichen Drücken gibt es im Allgemeinen keine Glimmentladung, vor allem keine DC-artige Glimmentladung. Vielmehr ist die Bogenentladung die einzige stabile Entladungsform. Man kann bei diesen Drücken nur die Pfade, über die die Bogenentladung stattfindet, mit Magnetfeldern beeinflussen. Bekannt sind z.B. durch den Einfluss eines Magnetfeldes rotierende Lichtbögen. Es hat sich jedoch gezeigt, dass es bei Drücken oberhalb von 100 mbar unmöglich ist, eine Entladung mit Glimmcharakteristik mithilfe von heute erzeugbaren Magnetfeldern zu erzielen.

Weiters bekannt ist die magnetische Beeinflussung einer elektrischen Entladung bei sehr kleinen Drücken durch Ablenkung bewegter geladener Teilchen mithilfe von Zyklotronen, magnetischen Spiegeln, magnetischen Käfigen etc. Die Anwendung dieser Vorrichtungen setzt jedoch eine Vorhersehbarkeit der Teilchenbahnen voraus. Dies wiederum setzt voraus, dass die Gasteilchen selten kollidieren, da nach einem Stoß die Teilchenbahn nicht mehr vorhersehbar ist. Als Vorbedingung gilt also eine freie Weglänge der Teilchen, die mindestens in der Größenordnung der verwendeten Kammern bzw. Gefäße liegen muss. Man spricht in diesem Zusammenhang vom "molekularen" Druckbereich. Um eine freie Teilchenweglänge von nur 10 cm zu erhalten darf der Druck etwa 10⁻³ mbar nicht übersteigen (für Elektronen ca. 10⁻² mbar). Nun ist es aber nur schwer möglich, eine Behandlungsanlage zu bauen, die sich für die Prozessierung eines Endlosmaterials eignet und die im niedrigen molekularen Druckbereich in einer gewählten Gasatmosphäre operiert, ohne dass Umgebungsluft wenigstens teilweise in die Entladungskammer hineinströmt. Daher ist es wirtschaftlich und technisch nicht vertretbar, eine Anlage zur Endlosmaterialbehandlung mittels eines Plasmas, die auf den Effekten eines Zyklotrons, magnetischen Spiegels, magnetischen Käfigs oder eines Magnetische Tunnels basiert, zu bauen, da beim Einleiten des Endlosmaterials in die Behandlungskammer im Durchlaufverfahren aufgrund des niedrigen Arbeitsdrucks immer etwas Umgebungsluft in die Behandlungskammer gelangen wird, die in den meisten Anwendungsfällen die Endlosinaterialoberfläche unbrauchbar macht. Dichtet man hingegen das Endlosmaterial vor und nach der Behandlungskammer hermetisch gegenüber der Umgebungsluft ab, so wird entweder das Endlosmaterial verformt, oder die Abdichtung wird schnell verschleißen. Macht man die Öffnungen, durch die das Endlosmaterial in die Behandlungskammer geführt wird, etwas größer als den Querschnitt des Endlosmaterials, so entstehen Blenden.

Des Weiteren ist die Dauerbetriebsfähigkeit einer Plasmabehandlungsanlage für nicht vollkommen saubere Endlosmaterialien, deren Entladungkammer im molekularen Druckbereich arbeitet (also für alle Anlagen, die auf oben erwähnten magnetische Effekten beruhen) eingeschränkt. Der Grund für diese Einschränkung liegt in der Tatsache, dass die von der Endlosmaterialoberfläche abgeschlagenen Verunreinigungen nicht vom Gas abtransportiert werden, sondern sich auf Anlagenteilen ablagern, da aufgrund der niedrigen Teilchendichte die Verunreinigungsteilchen auf ihrem Weg von der Oberfläche des Endlosmaterials zu den Anlagenteilen nicht oder kaum durch Kollisionen mit Gasteilchen behindert werden. So muss eine solche Anlage immer wieder geöffnet und gereinigt werden.

Es erscheint nun wünschenswert, mittels Druckstufungen ein Blenden- und Schleusensystem aufzubauen, das darauf basiert, dass Gas durch eine Blende ausschließlich von einem höheren Druckniveau zu einem niedrigeren strömt. So wäre es von großem Vorteil, wenn wenigstens eingansseitig eine Vorkammer vorhanden wäre, in der ein geringerer Druck als der Arbeitsdruck in der Behandlungskammer herrschen würde, so dass Gas aus der Behandlungskammer entgegen der Endlosmaterialbewegung unipolar in die Vorkammer strömen würde (in die eingangsseitig zwangsweise auch etwas Umgebungsluft einströmt). Dieser Vorschlag setzt jedoch einen relativ hohen, rein viskosen Arbeitsdruck voraus, da nur in einem rein viskosen Druckbereich die Annahme stimmt, dass Gas durch eine Blende nur vom höheren zu niedrigerem Druck strömt. Im molekularen Druckbereich hingegen, wo die Stöße zwischen den Gasteilchen selten sind, können Gasteilchen fast ungehindert durch eine Blende hindurch auch von Gefäßen mit niedrigerem zu solchen mit höherem Druckniveau fliegen.

Deshalb ist mitunter die Fähigkeit der erfindungsgemäßen Anlage, im angegebenen, viskosen Druckbereich zu operieren, besonders wichtig.

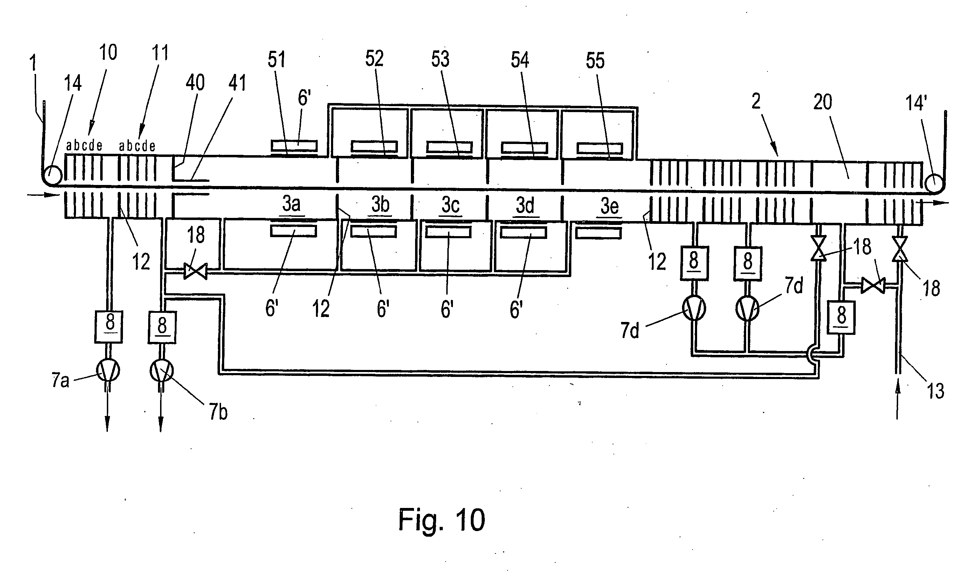

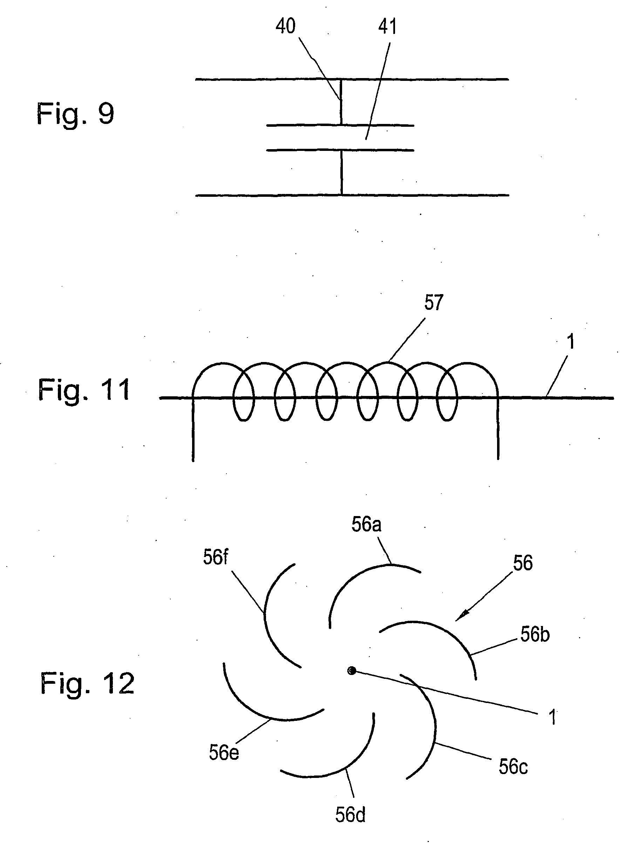

Die vorliegende Erfindung sieht aber noch eine weitere Maßnahme vor, um die Druckgrenze, bis zu der Blenden funktionieren, in geeigneter Weise zu verschieben. Dies wird erfindungsgemäß dadurch erreicht, dass, wie in Fig. 9 im Längsschnitt dargestellt, eine Schleuse 40 eine Schleusenöffnung 41 aufweist, die als Tunnel ausgebildet ist, der vorzugsweise ein Verhältnis zwischen Tunnellänge zu lichter Weite des Tunnels von zumindest 2:1, bevörzugt zumindest 4:1, aufweist. Auf diese Weise lässt sich ein Mehrkammersystem mit dazwischenliegenden Schleusen, wie z.B. in den Figuren 7 und 10 der WO 2004/073009 A2 offenbart, wesentlich verbessern. Insbesondere ist gemäß der Erfindung vorgesehen, dass jene Schleusen als Tunnels ausgebildet sind, bei denen auf beiden Seiten Unterdruck herrscht.

Die Maßnahme, Schleusenöffnungen als Tunnels auszubilden, beruht auf der Erkenntnis, dass das Verhältnis zwischen Gefäßabmessungen und der mittleren freien Weglänge der Teilchen dafür maßgeblich ist, ob sich das System im molekularen oder viskosen Druckbereich befindet. Dabei ist der Tunnel als Gefäß anzusehen, dessen Größe nur einen Bruchteil von jener der Behandlungskammer beträgt. Um im Tunnel viskose Druckzustände zu erreichen, muss der Druck also um den gleichen Faktor höher liegen als der Grenzdruck zwischen viskos und molekular in der Behandlungskammer.

Unter Ausbildung von Schleusen mit Tunnels lässt sich ein Gas-Rückgewinnungssystem realisieren, bei dem Gas aus einer Nachkammer in eine Vorkammer und/oder Nachkammer mit höherem Druckniveau umwälzbar ist. Weiters können die Vorkammern in Unterkammern unterteilt und/oder das Nachkammernsystem aus einzelnen Nachkammern zusammengesetzt sein, wobei zwischen den Unterkammern bzw. den Nachkammern Schleusenöffnungen vorgesehen sind, durch welche das Endlosmaterial reibungsarm durch die Unterkammern bzw. die Nachkammern hindurch führbar ist, wobei zumindest einige der Schleusenöffnungen als Tunnels ausgebildet sind.

Nachfolgend werden zwei Varianten einer Anlage zur Plasmaprozessierung mit einem Vor-und Nachkammersystem beschrieben, die ein Gas-Rückgewinnungssystem umfasst.

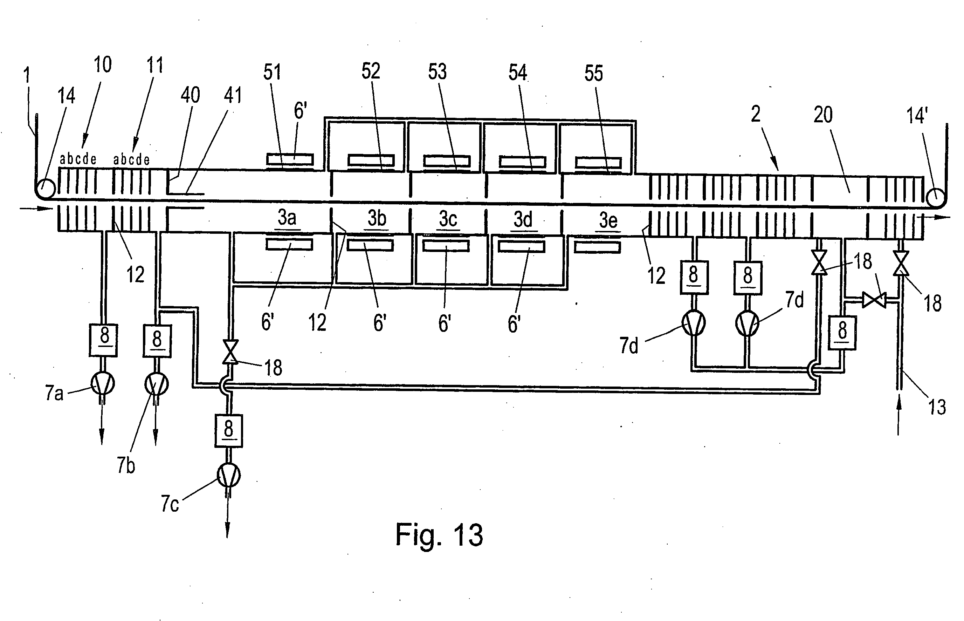

Die Figuren 10 und 13 zeigen zwei Varianten einer erfindungsgemäßen Anlage zur Plasmaprozessierung von Endlosmaterial 1. Das Endlosmaterial 1 wird über die Führungsrolle 14 durch zwei Vorkammersysteme 10, 11 hindurchgeführt, die jeweils aus mehreren Unterkammern bestehen, z.B. 10a, 10b ... 10e, und jeweils an der letzten Unterkammer 10e, 11e mittels Pumpen 7a, 7b ausgepumpt werden, wobei zwischen den Unterkammern 10e, 11e und den Pumpen 7a, 7b Filter 8 zwischengeschaltet sind. Nach dem Vorkammersystem 11 geht das Endlosmaterial 1 durch fünf Entladungskammern 3a, 3b ... 3e zu dem Nachkammersystem 2, das wiederum in eine Vielzahl an Unterkammern unterteilt ist, wobei einer langen Nachkammer, die als Kühleinheit 20 fungiert, kleinere Kammern vor-und nachgeschaltet sind, die wiederum miteinander durch Schleusenöffnungen verbunden sind. Die Vorkammer 11 ist von der ersten Entladungskammer 3a durch eine Schleuse 40 mit einem Tunnel 41 als Schleusenöffnung getrennt. Die Vorkammern 10, 11 sowie ihre Unterkammern, die Entladungskammern 3a - 3e, die Entladungskammer 3e vom Nachkammersystem 2 sowie die Unterkammern des Nachkammersystems 2 sind voneinander durch blendenförmige Schleusen 12 getrennt. Die Vielzahl an Schleusenöffnungen in Kombination mit einer einstellbaren Druckstufung minimiert den Gasfluss, den Gasverbrauch und die nötige Pumpleistung. Das Gas strömt aus dem Nachkammernsystem 2 in die fünfte Entladungskammer 3e und von dort, noch bevor es in Berührung mit der Entladung gekommen ist, weiter in die vorgeschalteten Endladungskammern 3d - 3a. Ein kleiner Teil des Gases wird gemäß der Ausführungsform von Fig. 10 aus der Entladungskammer 3 a mittels der Vakuumpumpe 7b abgesaugt, die auch für die Absaugung der Vorkammer 11e zuständig ist. Gemäß der Ausführungsform von Fig. 13 ist für die Gasabsaugung aus der Entladungskammer 3a eine eigene Pumpe 7c mit vorgeschaltetem Filter 8 vorgesehen. Bei beiden Ausführungen wird ein Teil des Gases durch die Vakuumpumpen 7d innerhalb des Nachkammersystems 2 zirkuliert und der Kühleinheit 20 zugeführt. Hiermit wird gewährleistet, dass allen Entladungskammern frisches, sauberes Gas zugeführt wird, wogegen die Mehrzahl der Ausdampfungen, die ja aus dem Endlosmaterial 1 in der ersten Entladungskammer 3a freigesetzt werden, mit einer relativ kleinen Menge des Arbeitsgases vermischt über die Vakuumpumpe 7b bzw. die Vakuumpumpe 7c nach außen gelangt. Die Gaszuführung in die gesamte Anlage erfolgt durch eine Leitung 13 mit einem relativ sehr kleinen Überdruck gegenüber dem Atmösphärendruck (z.B.: 0,1 bar). Der Druck in der als Kühleinheit ausgebildeten Nachkammer 20 ist somit der höchste in der gesamten Anlage , was dort eine bessere Kühlleistung des Endlosmaterials 1 zu Folge hat. So kann ein Rückgewinnungssystem verwirklicht werden, bei dem Gas aus dem Nachkammersystem 2 in die Nachkammer 20 mit höherem Druckniveau umgewälzt wird. Als Arbeitsgas fungiert hier beispielsweise Helium. Dieses Rückgewinnungssystem hat sich durch besondere Effizienz bewährt. Die einzelnen Entladungskammern 3a bis 3e sind jeweils mit einer separaten Außenelektrode 51 - 55 und einer Elektromagnetanordnung 6' versehen. Die elektrische Versorgung der Außenelektroden 51 - 55 kann beispielsweise wie in Fig. 8 dargestellt erfolgen, die Magnetfelderzeugung in den Entladungskammern 3a - 3e erfolgt mittels der Elektromagnetanordnungen 6', die außerhalb der Entladungskammern 3a - 3e konzentrisch angeordnet sind. Zwischen den Entladungskammern 3a, 3b und den Elektromagnetanordnungen 6' befindet sich eine Kühlflüssigkeit.

Die Führungsrollen 14, 14' sind geerdet und kontaktieren (erden) das Endlosmaterial 1. Sowohl die Entladungskammern 3a - 3e wie auch die Endlosmaterial-Kühleinheit 20 werden beispielsweise mittels Öl flüssigkeitsgekühlt. Nach dem Nachkammersystem 2 kann weiters eine Flüssigkeitskühlstufe, insbesondere eine Wasserkühlstufe, vorgesehen sein. Der ganze Prozess kann über ein Regel- bzw. Steuersystem und über insbesondere regel- bzw. steuerbare Ventile 18 kontrolliert werden. Alternativ können zu diesen Zwecken auch die eingesetzten Pumpen mittels Frequenzumrichter über die Drehzahl in ihrer Saugleistung variiert werden.

Die entsprechenden optimalen Drücke werden über Vakuumpumpen 7a bis 7d und gegebenenfalls über Filter 8 und Ventile 18 erzeugt, womit bei gegebenem Magnetfeld der benötigte Druck zur Konzentration des Plasmastromes im Bereich des Magnetfeldes erzielt werden kann. Für höherwertige Anwendungen macht es Sinn, die Vakuumpumpen, insbesondere die zur Gasumwälzung eingesetzten Vakuumpumpen, als trockene Vakuumpumpen auszuführen. Besonders gut eignen sich da Spiralpumpen, Schraubenpumpen, Kolbenpumpen, Membranpumpen, in besonderen Ausführungen auch Klauenpumpen und Drehkolbenpumpen unterschiedlicher Ausführungen.

Durch die Ausgestaltung der erfindungsgemäßen Anlage zur Plasmaprozessierung mit inhärenter Konstantstromquelle als Energieversorgungseinheit und Anlegen eines starken Magnetfelds senkrecht zur Entladungsrichtung wird eine Anlage geschäffen, die energiesparend, gassparend und im Dauerbetrieb eine Plasmabehandlung (v.a. durch Ionenbeschuss) von nicht sauberen und auch nicht vollkommen gleichmäßig mit Verschmutzungen bedeckten Endlosmaterialien mit hoher Behandlungsintensität ermöglicht. Es werden mit dieser Anlage auch Endlosmaterialien gleichmäßig behandelbar, die nach dem Stand der Technik nicht behandelbar waren. Zusätzlich liegt durch oben beschriebene Maßnahmen der Arbeitsdruck klar im viskosen Druckbereich, wodurch das Einleiten und Ausleiten des Endlosmaterials in die Entladungskammer(n) sehr vereinfacht wird sowie ein effizienter Abtransport der von der Endlosmaterialoberfläche abgeschlagenen Substanzen ermöglicht wird.

Die Erfinder haben weiters erkannt, dass ein vollkommen neuer Entladungsmodus in der Entladungskammer entsteht, wenn die erfindungsgemäße Anlage so ausgelegt wird, dass die folgenden Bedingungen zutreffen:
➢ Es liegt in der Entladungskammer bzw. den Entladungskammern ein sehr starkes Magnetfeld an, das im Wesentlichem in Längsrichtung des Endlosmaterials ausgerichtet ist und das die Querschnittsfläche zwischen der Außenelektrode und dem Endlosmaterial zumindest nahe dem Endlosmaterial und zumindest über den Großteil der Längsausdehnung der Elektrode durchfließt. Dieses Magnetfeld sollte zumindest 120 mT, vorzugsweise zumindest 400 mT, am bevorzugtesten zumindest 700 mT betragen.
➢ Die Außenelektrode ist so beschaffen, dass sie in der Projektion auf die Querschnittsebene des Endlosmaterials das Endlosmaterial optisch dicht umhüllt. Die durch diese zwingende Vorbedingung hervorgerufene Entladungsform ist äußerst überraschend und nach dem Stand der Wissenschaft nicht erklärbar. Die Merkmale dieser Entladungsform zeigen jedenfalls, dass es sich hier um eine wirklich neue Entladungsform, also um ein neues physikalisches Phänomen, handelt.
➢ Es herrscht in der Entladungskammer ein Gasdruck zwischen 0,1 und 100 mbar, besser zwischen 0,5 und 50 mbar, am besten zwischen 1 und 10 mbar,
➢ Es besteht ein großes Verhältnis zwischen der Querschnittsfläche innerhalb der Außenelektrode (oder zumindest deren Projektion auf die Querschnittsebene) und dem Querschnitt der kleinsten konvexen einhüllenden Fläche des Querschnittes der inneren Elektrode (d.h. in der Praxis meistens des Querschnitts des Endlosmaterials, das als innere Elektrode fungiert). Dieses Verhältnis sollte zumindest 4:1, besser zumindest 10:1, und vorzugsweise zumindest 20:1 betragen.

Der neue Entladungsmodus wird als magnetisch rotationsdiffus gemachte Entladung bezeichnet, und in diesem Dokument mit MRDE abgekürzt.

Im einfachsten Fall ist die Außenelektrode, die in der Projektion auf die Querschnittsebene des Endlosmaterials das Endlosmaterial optisch dicht umhüllt als ein gerades Rohr 51-55 ausgebildet (siehe Fig. 8), wobei die Innenelektrode ein Draht ist, der als Endlosmaterial durch das Rohr der Außenelektrode hindurchgeführt ist. Der Draht ist dünn im Vergleich zum Rohr. Das Magnetfeld wird zweckmäßig mittels einer Zylinderspule, deren Symmetrieachse mit der Drahtlängsrichtung zusammenfällt, erzeugt.

Ist die Innenelektrode kein runder Draht, sondern ein beliebiges Profil, dann muss die einhüllende Fläche des Profilquerschnittes immer noch klein sein im Vergleich zur Innenquerschnittsfläche der Außenelektrode.

Die Form der Außenelektrode ist deshalb so wichtig, da sie die Rotation der Entladungsschwerpunkte ermöglichen muss. Abgesehen vom Rohr ist auch eine Schraubenlinie als Außenelektrode 57 geeignet, wie in Fig. 11 in Seitenansicht dargestellt, wenn die Gasgeschwindigkeit der Steigung der Schraubenlinie und die Rotation des Schwerpunktes des äußeren Pols der Entladung der Krümmung der Schraubenlinie entspricht. Die schraubenförmige Außenelektrode 57 umgibt koaxial das Endlosmaterial 1.

Wie in Fig. 12 im Querschnitt dargestellt, kann die Außenelektrode 56 auch aus einzelnen Segmenten 56a bis 56f zusammensetzt sein, die sich in der Drehrichtung des Entladungsaußenpols spiralförmig aufweiten, so dass sie das Endlosmaterial 1 nicht einzeln, sondern erst alle zusammen vollständig umschließen. Auch diese segmentförmige Außenelektrode 56 erfüllt die Forderung der optisch dichten Umhüllung des Endlosmaterials in der Projektion auf die Querschnittsebene des Endlosmaterials. Es sei erwähnt, dass sehr kleine Unterbrechungen dieser geforderten optisch dichten Umhüllung von der Entladung verkraftet werden können. Es ist in so einem Fall die Entladungsstörung zwar feststellbar (und wird für die Prozessdiagnostik ausgewertet), für den Plasmaprozess am Endlosmaterial ist sie aber meist vernachlässigbar.

Weiters ist es zur Verhinderung des Entstehens von Bogenentladungen wichtig, im Falle eines Magnetfelds, das nicht über die gesamte Behandlungslänge das Endlosmaterial umhüllt, eine starke Gasströmung in der Entladungskammer vorzusehen. Durch die starke Gasströmung wird eine kurze Verweilzeit der Gasteilchen in diesen Bereichen erzielt, die den Umschwung zur Bogenentladung unwahrscheinlicher macht. Speziell bei einer Permanentmagnetanordnung muss damit gerechnet werden, dass theoretisch mindestens ein, in der Praxis sogar mindestens zwei Nulldurchgänge des Axialmagnetfeldes am Endlosmaterial im Bereich der starken Magnetfelder stattfinden. Diese Stellen sind für die Entladung gefährlich, da aufgrund der starken Magnetfelder in unmittelbarer Umgebung sehr viele Ladungsträger vorhanden sind, die zu diesen Nullstellen diffundieren können, jedoch kein Axialmagnetfeld vorhanden ist, um eine Bogenentladung zu verhindern. Auch an diesen Stellen kann durch das Vorsehen einer starken Gasströmung, die die Nullstellen kreuzt, also näherungsweise parallel mit dem Endlosmaterial verläuft, die Wahrscheinlichkeit des Umschlagens in eine Bogenentladung stark reduziert werden.

Eine gepulste Zufuhr der elektrischen Entladungsenergie zur Entladungsstrecke begünstigt das Auftreten von MRDE, ist aber nicht in jeder Konstellation erforderlich.

Mit MRDE sind stufenlos und ohne ein Anzeichen für eine physikalische Unstetigkeit sehr kleine (um 1W pro cm²) bis extrem hohe Plasmabehandlungsdichten von mindestens 2 kW pro cm² Endlosmaterialoberfläche erzielbar, ohne dass die Entladung räumlich oder zeitlich unstabil wird.

Bei MRDE handelt es sich um eine Entladungsform, bei der im Bereich nahe der Außenelektrode bewegte (rotierende), mit hoher Wahrscheinlichkeit auch immer verdichtete Entladungszustande auftreten (daher die Forderung, das Endlosmaterial solle mindestens fast vollständig vom Magnetfeld umhüllt werden). Im inneren Bereich nahe dem Endlosmaterial "zerblasen" sich aber diese Verdichtungen, so dass das Endlosmaterial nicht spiralförmig, sondern flächig gleichmäßig behandelt wird. Für das Verhalten der Entladung nahe dem Endlosmaterial ist es wichtig, dass die Krümmungsradien der Ladungsträger, zumindest der Elektronen, kleiner gleich der (druckbedingten) freien Weglängen sind.

Folgende Eigenschaften trennen die neue Entladungsform MRDE von den bis dato bekanten Entladungsformen, vor allem von denen, die im gleichen Druckbereich unter Einfluss von Magnetfeld stattfinden können:
Das in allgemeinen als Kathode geschaltete Endlosmaterial wird über seine Oberfläche gleichmäßig behandelt (Glimmeigenschaft), brennt bei sehr kleinen Leistungsdichten konstant (Glimmeigenschaft), kann aber kontinuierlich bis zu extrem hohen Behandlungsdichten im Bereich kW/cm² betrieben werden (was eindeutig die Domäne von Bogenentladungen ist), ohne dass sich bei Vergrößerung der eingekoppelten Leistung die Flächenverteilung der Entladung maßgeblich ändern würde (weder Bogen- noch Glimmentladungseigenschaft).

Damit MRDE auftreten kann, muss die Außenelektrode das Endlosmaterial fast vollständig umschließen. Diese Bedingung ist mit keinem Effekt erklärbar, der auf bekannten magnetischen Effekten von Glimmentladungen basiert. In einem Experiment wurde der Einfluss der Geometrie der Außenelektrode auf ein Endlosmaterial, bestehend aus Runddraht von 1,2 mm Durchmesser aus nicht ferromagnetischem, rostfreiem Edelstahl bei gleicher Gasatmosphäre (He, Ar oder N₂ in einstelligem Millibarbereich) und Gasströmung sowie gleicher Magnetfeldanordnung (600 mT parallel mit der Endlosmateriallängsrichtung) untersucht. Die Außenelektrode wurde hergestellt, indem ein gekühltes nicht ferromagnetisches Edelstahlrohr mit einem Innendurchmesser von 41 mm an seiner Innenwand mit einem bzw. zwei Quarzglasrohr(en) unvollständig abgedeckt und damit teilweise isoliert wurde. Die freiliegenden Stellen des Edelstahlrohrs fungierten als Außenelektroden. Es wurden zwei Anordnungen verglichen, wobei in der ersten Anordnung die freiliegende Elektrodenfläche ein Ring zwischen zwei senkrecht abgeschnittenen Quarzglasrohren von 8 mm Länge war, so dass sich als Außenelektrode ein 41 mm durchmessender, 8 mm hoher Zylinder ergab. Bei der zweiten Anordnung deckte ein einziges Quarzglasrohr, das zwei Ausschnitte aufwies, die Innenfläche des Edelstahlrohrs ab, wobei die Ausschnitte die freiliegenden Außenelektrodenflächen definierten. Die Ausschnitte waren zwei einander gegenüberliegende Längsschlitze von 50 mm Länge und 10 mm Breite Es wurde darauf geachtet, dass bei beiden Anordnungen die freiliegenden Elektrodenflächen sich im selben Plateau mit annähernd gleichem, homogenen Magnetfeld befanden, dass die Oberflächen der Außenelektroden annähernd gleich groß waren und dass die Gesamtlänge der Ränder der Außenelektroden annähernd gleich war. Zu erwarten wäre nach dem Stand der Technik, dass sich beide Anordnungen ähnlich verhalten würden. Beobachtet wurde jedoch (bei He, 3 mbar), dass bei der zweiten Anordnung bei einer Plasmaspannung von 800 V der Strom 200 mA nicht überschritt, während er bei erster Anordnung bei sonst identischen Bedingungen schon bei niedrigeren Spannungen (um 600 V) 10 A überschritten. Bei Ar als Gasatmosphäre zeigte sich tendenziell ein ähnliches Verhalten, jedoch waren nicht so hohe Ströme prozessierbar, weil Ar stärker zu Bogenentladungen tendiert. Bei Stickstoff war der Verlauf ähnlich wie bei He, wobei die Brennspannung etwas höher ist. Durch das Nitrieren der Oberflächen litt allerdings die Reproduzierbarkeit des Experiments. Mit diesem Experiment wurde jedoch eindeutig bewiesen, dass rotierende Entladungszustände (mit großer Wahrscheinlichkeit Verdichtungen) zumindest im äußeren Volumenbereich (und mit großer Wahrscheinlichkeit eine Ablenkung der geladenen Gasteilchen, die in Abhängigkeit vom der Entfernung vom Endlosmaterial zu sehr unterschiedlichen Winkelgeschwindigkeiten einer Entladungsverdichtung führen würde) für die neue Entladungsform verantwortlich sind und nicht Effekte, die eine Vorhersehbarkeit der Bahnen der geladenen Teilchen über längere, mindestens mit Gefäßgröße vergleichbare Strecken zu Grundlage haben, wie die oben beschriebenen magnetischen Effekte.

## Patentansprüche

1. Anlage zur Plasmaprozessierung eines Endlosmaterials mit zumindest einer evakuierbaren Entladungskammer (3a), durch die hindurch das Endlosmaterial (1) kontinuierlich transportierbar ist, wobei jede Entladungskammer (3a) eine Außenelektrode (5, 51-57) aufweist, die in Bezug auf das Endlosmaterial elektrisch isoliert angeordnet ist, einer Einrichtung zur Einstellung einer Gasatmosphäre in der wenigstens einen Entladungskammer, und einer Energieversorgungseinrichtung (30) zur Abgabe von elektrischer Entladungsenergie an zwischen der Außenelektrode einer jeweiligen Entladungskammer und dem Endlosmaterial als Innenelektrode definierte Entladungsstrecken (G), **dadurch gekennzeichnet, dass** die Energieversorgungseinrichtung (30) eine zur pulsförmigen Abgabe der Entladungsenergie ausgebildete inhärente Stromquelle ist, die zumindest eine Induktivität (32) als Energiespeicher aufweist, die mit einer ihr zugeordneten Entladungsstrecke (G) oder sukzessive mit mehreren ihr zugeordneten Entladungsstrecken zusammenschaltbar ist.

2. Anlage nach Anspruch 1, weiter **dadurch gekennzeichnet, dass** die zumindest eine Induktivität (32) während eines Energieabgabepulses immer mit genau einer Entladungsstrecke (G) zusammengeschaltet ist, und vorzugsweise in den Energieabgabepulspausen eine Umschaltung zu einer anderen Entladungsstrecke erfolgt.

3. Anlage nach Anspruch 1 oder 2, weiter **dadurch gekennzeichnet, dass** die Induktivität (32) nur während der Energieabgabepulse geladen wird.

4. Anlage nach Anspruch 1 oder 2, weiter **dadurch gekennzeichnet, dass** die Induktivität (32) nur während der Energieabgabepulspausen geladen wird.

5. Anlage nach einem der vorhergehenden Ansprüche, weiter **dadurch gekennzeichnet, dass** die Energieversorgungseinrichtung (30) eine Ausgangsspannungsbegrenzungsschaltung (33) aufweist.

6. Anlage nach einem der vorhergehenden Ansprüche, weiter **dadurch gekennzeichnet, dass** die Energieversorgungseinrichtung ein elektronisches Schaltwerk zur Abgabe von Energiepulsen beliebiger Polarität an die Entladungsstrecke aufweist.

7. Anlage nach einem der vorhergehenden Ansprüche, weiter **dadurch gekennzeichnet, dass** zwischen der zumindest einen Induktivität der Energieversorgungseinrichtung und der zumindest einen Entladungskammer zumindest eine Entzerrschaltung angeordnet ist, um die parasitären Hochfrequenzeffekte bzw. deren Einflüsse, wie z. B. die Induktivität der Stromleiter, die Kapazität der Entladungskammer bzw. der Elektroden u. Ä. zu unterdrücken bzw. zu kompensieren.

8. Anlage nach einem der vorhergehenden Ansprüche, weiter **dadurch gekennzeichnet, dass** mehrere Entladungskammern hintereinander angeordnet sind, durch die das Endlosmaterial hindurchläuft, ohne in oder zwischen den Entladungskammern kontaktiert zu werden.

9. Anlage nach einem der vorhergehenden Ansprüche, weiter **dadurch gekennzeichnet, dass** eine Hochleistungsmagnetanordnung (6, 6') vorgesehen ist, die im Bereich der Außenelektrode (5) ein starkes, im wesentlichen parallel mit dem Endlosmaterial ausgerichtetes Magnetfeld von zumindest 120 mT, vorzugsweise von zumindest 400 mT, am bevorzugtesten von zumindest 700 mT, erzeugt.

10. Anlage nach Anspruch 9, weiter **dadurch gekennzeichnet, dass** die Hochleistungsmagnetanordnung (6') dazu ausgebildet ist, ein über den Verlauf seiner Längsausdehnung im Wesentlichen homogenes Magnetfeld zu erzeugen.

11. Anlage nach Anspruch 10, weiter **dadurch gekennzeichnet, dass** die Hochleistungsmagnetanordnung (6') eine die Außenelektrode umgebende Spule (63) ist, die im Wesentlichen koaxial mit dem Endlosmaterial (1) angeordnet ist, wobei die Spule vorzugsweise als gekühlte, insbesondere flüssigkeitsgekühlte, Spule, optional als supraleitender Elektromagnet, ausgebildet ist.

12. Anlage nach Anspruch 9, weiter **dadurch gekennzeichnet, dass** die Hochleistungsmagnetanordnung (6) dazu ausgebildet ist, ein über den Verlauf seiner Längsausdehnung inhomogenes Magnetfeld zu erzeugen, dessen Maxima die Maxima der Behandlungsintensität des Endlosmaterials festlegen.

13. Anlage nach Anspruch 12, weiter **dadurch gekennzeichnet, dass** die Hochleistungsmagnetanordnung (6) als Permanentmagnetanordnung ausgebildet ist, die insbesondere anisotrope Permanentmagneten (61), vorzugsweise aus NdFeB-Permanentmagneten, umfasst, welche im Wesentlichen die Seitenwände eines Prismas mit polygonalem Querschnitt bilden.

14. Anlage nach Anspruch 13, weiter **dadurch gekennzeichnet, dass** Eisenschlusselemente (62) vorgesehen sind, die das Magnetfeld der Permanentmagnetanordnung (6) im Bereich der Gasentladung konzentrieren, wobei vorzugsweise die Magnetisierungsrichtung der Magnete im Wesentlichen radial in Bezug auf den Querschnitt des Prismas gerichtet ist.

15. Anlage nach einem der Ansprüche 9 bis 14, weiter **dadurch gekennzeichnet, dass** die Außenelektrode (5) in ihrer Längserstreckung nicht aus dem Magnetfeld herausragt.

16. Anlage nach einem der Ansprüche 9 bis 14, weiter **dadurch gekennzeichnet, dass** die Außenelektrode in ihrer Längserstreckung an mindestens einer Seite aus dem Magnetfeld herausragt.

17. Anlage nach einem der vorhergehenden Ansprüche, weiter **dadurch gekennzeichnet, dass** die Außenelektrode (5, 51-55, 56, 57) das Endlosmaterial in der Projektion auf seine Querschnittsebene im Wesentlichen vollständig optisch dicht umhüllt.

18. Anlage nach Anspruch 17, weiter **dadurch gekennzeichnet, dass** die Außenelektrode (5) einen Teil der Entladungskammer definiert und vorzugsweise kühlbar, insbesondere flüssigkeitskühlbar, ist.

19. Anlage nach Anspruch 17 oder 18, weiter **dadurch gekennzeichnet, dass** das Verhältnis zwischen der Querschnittsfläche innerhalb der Außenelektrode (5, 51-57) und der Querschnittsfläche der kleinsten konvexen Einhüllenden des Endlosmaterials (1) zumindest 4:1 beträgt, besser zumindest 10:1, und vorzugsweise zumindest 20:1.

20. Anlage nach einem der vorhergehenden Ansprüche, weiter **dadurch gekennzeichnet, dass** der Druck in der Entladungskammer auf 0,1 bis 100 mbar, bevorzugter auf 0,5 bis 50 mbar, am bevorzugtesten auf 1 bis 10 mbar einstellbar ist.

21. Anlage nach einem der vorhergehenden Ansprüche, wobei die Einrichtung zur Einstellung einer Gasatmosphäre ein Vorkammern- und/oder ein Nachkammernsystem umfasst, wobei zwischen den Kammern dieser Systeme Schleusenöffnungen vorgesehen sind, durch welche das Endlosmaterial hindurchführbar ist, **dadurch gekennzeichnet, dass** zumindest eine Schleusenöffnung als Tunnel (41) ausgebildet ist, der vorzugsweise ein Verhältnis zwischen Tunnellänge zu lichter Weite des Tunnels von zumindest 2:1, bevorzugt zumindest 4:1, aufweist und sowohl als eigenständiges Bauelement wie auch als eine besondere Ausführungsform anderer Bauelemente ausgeführt sein kann.

22. Anlage nach Anspruch 21, weiter **dadurch gekennzeichnet, dass** jene Schleusen als Tunnels (41) ausgebildet sind, bei denen auf beiden Seiten Unterdruck und unterschiedliche Gaszusammensetzungen herrschen.

23. Anlage nach Anspruch 21 oder 22, weiter **dadurch gekennzeichnet, dass** die Einrichtung zur Einstellung einer Gasatmosphäre ein Rückgewinnungssystem umfasst, bei dem Gas aus einer Nachkammer in eine Vorkammer und/oder Nachkammer mit höherem Druckniveau umwälzbar ist.

24. Anlage nach Anspruch 23, weiter **dadurch gekennzeichnet, dass** die Vorkammern in Unterkammern unterteilt sind und/oder das Nachkammernsystem aus einzelnen Nachkammern zusammengesetzt ist, wobei zwischen den Unterkammern bzw. den Nachkammern Schleusenöffnungen vorgesehen sind, über welche das Endlosmaterial reibungsarm durch die Unterkammern bzw. die Nachkammern hindurch führbar ist.

## Claims

1. A device for plasma processing a continuous material with at least one discharge chamber (3a) that can be evacuated and through which the continuous material (1) may be continuously transported, each discharge chamber (3a) having an outer electrode (5, 51-57) arranged electrically insulated in regard to the continuous material, a device for adjusting a gas atmosphere in the at least one discharge chamber, and an energy supply device (30) for delivering electric discharge energy to discharge sections (G) defined as an inner electrode between the outer electrode of a respective discharge chamber and the respective continuous material, **characterized in that** the energy supply device (30) is an inherent source of current adapted for the pulse-like delivery of discharge energy, with having at least one inductor (32) as an energy storage which may be interconnected with a discharge section (G) assigned or with several discharge sections assigned in succession.

2. The device according to claim 1, further **characterized in that** the at least one inductor (32) is interconnected with exactly one discharge section (G) during one energy delivery pulse and is switched over to another discharge section preferably in the energy delivery pulse pauses.

3. The device according to claim 1 or claim 2, further **characterized in that** the inductor (32) is only charged during the energy delivery pulses.

4. The device according to claim 1 or claim 2, further **characterized in that** the inductor (32) is only charged during the energy delivery pulse pauses.

5. The device according to one of the claims above, further **characterized in that** the energy supply device (30) comprises output voltage limiting circuits (33).

6. The device according to one of the claims above, further **characterized in that** the energy supply device comprises an electronic switching circuit for delivering energy pulses of any polarity to the discharge section.

7. The device according to any one of the claims above, further **characterized in that** there is arranged between the at least one inductor of the energy supply device and the at least one discharge chamber at least one equalizing circuit, in order to suppress and compensate, respectively, parasitic high frequency effects and their influences,
respectively, such as, for example, the inductivity of the conductors, the capacity of the discharge chamber and the electrodes, or the like.

8. The device according to one of the claims above, further **characterized in that** a plurality of discharge chambers are arranged one after the other, through which the continuous material is passed through, without being contacted in or inbetween the discharge chambers.

9. The device according to one of the claims above, further **characterized in that** there is provided a high performance magnet assembly (6, 6') generating in the region of the outer electrode (5) a strong magnetic field with an essentially parallel orientation in regard to the continuous material of at least 120 mT, preferably of at least 400 mT, and most preferably of at least 700 mT.

10. The device according to claim 9, further **characterized in that** the high performance magnet assembly (6') is adapted to generate an essentially homogenous magnetic field along the length of its longitudinal extension.

11. The device according to claim 10, further **characterized in that** the high performance magnet assembly (6') is a coil (63) surrounding the outer electrode, arranged essentially coaxially with the continuous material (1), with the coil preferably being adapted as a cooled, especially liquid-cooled, coil, and optionally as a superconducting electromagnet.

12. The device according to claim 9, further **characterized in that** the high performance magnet assembly (6) is adapted to generate an inhomogeneous magnetic field along the length of its longitudinal extension, the maxima of which defining the maxima of the treatment intensity of the continuous material.

13. The device according to claim 12, further **characterized in that** the high performance magnet assembly (6) is adapted as a permanent magnet assembly, particularly comprising anisotropic permanent magnets (61), preferably of NdFeB permanent magnets, which form essentially the side walls of a prism with polygonal cross-section.

14. The device according to claim 13, further **characterized in that** there is made provision of yoke elements (62) concentrating the magnetic field of the permanent magnet assembly (6) in the area of the gas discharge, with the orientation of magnetization of the magnets being oriented essentially radially in regard to the cross-section of the prism.

15. The device according to one of the claims 9 to 14, further **characterized in that** the outer electrode (5) in its longitudinal extension does not project out of the magnetic field.

16. The device according to one of the claims 9 to 14, further **characterized in that** the outer electrode projects out of the magnetic field at at least one side of its longitudinal extension.

17. The device according to one of the claims above, further **characterized in that** the outer electrode (5, 51-55, 56, 57) optically envelops the continuous material in the projection onto its cross-sectional plane in an essentially complete way.

18. The device according to claim 17, further **characterized in that** the outer electrode (5) defines a part of the discharge chamber and preferably may be cooled, especially liquid-cooled.

19. The device according to claim 17 or claim 18, further **characterized in that** the ratio between the cross-sectional area within the outer electrode (5, 51-57) and the cross-sectional area of the smallest convex enveloping of the continuous material (1) is at least 4:1, preferably at least 10:1, and especially preferably at least 20:1.

20. The device according to one of the claims above, further **characterized in that** the pressure in the discharge chamber is adjustable to 0.1 to 100 mbar, preferably to 0.5 to 50 mbar, and most preferably to 1 to 10 mbar.

21. The device according to one of the claims above, with the device for adjusting a gas atmosphere comprising a prechambers system and/or an afterchambers system, with sluice openings being provided inbetween the chambers of these systems, through which the continuous material may be passed through, **characterized in that** there is provided at least one sluice opening as a tunnel (41), which has preferably a ratio between tunnel length and clear width of the tunnel of at least 2:1, preferably at least 4:1, and which may be formed as an independent component as well as a special embodiment of other components.

22. The device according to claim 21, further **characterized in that** those sluices with negative pressure and different gas combinations prevailing on both sides are formed as tunnels (41).

23. The device according to claim 21 or 22, further **characterized in that** the device for adjusting a gas atmosphere comprises a recovery system in which gas may be circulated from an afterchamber into a prechamber and/or an afterchamber with a higher pressure level.

24. The device according to claim 23, further **characterized in that** the prechambers are divided into sub-chambers and/or that the afterchambers system consists of individual afterchambers, with there being provided sluice openings between the sub-chambers and the afterchambers, respectively, through which the continuous material may be passed through the sub-chambers and the afterchambers, respectively, with only little friction.

## Revendications

1. Installation pour le traitement au plasma d'un matériau sans fin, comprenant au moins une chambre de décharge (3a) susceptible d'être évacuée, à travers laquelle le matériau sans fin (1) peut être transporté en continu, dans laquelle chaque chambre de décharge (3a) comprend une électrode extérieure (5, 51-57) qui est agencée de manière électriquement isolée par rapport au matériau sans fin, un système pour établir une atmosphère gazeuse dans ladite au moins une chambre de décharge, et un dispositif d'alimentation d'énergie (30) pour fournir une énergie de décharge électrique à des trajets de décharge (G) définis entre l'électrode extérieure d'une chambre de décharge respective et le matériau sans fin à titre d'électrode intérieure, **caractérisé en ce que** le dispositif d'alimentation d'énergie (30) est une source de courant inhérente réalisée pour fournir l'énergie de décharge sous forme d'impulsions, qui comprend au moins une inductance (32) à titre d'accumulateur d'énergie, laquelle peut être branchée à un trajet de décharge (G) qui lui est associé ou successivement avec plusieurs trajets de décharge qui lui sont associés.

2. Installation selon la revendication 1, **caractérisée en outre en ce que** ladite au moins une inductance (32) est branchée, pendant la fourniture d'une impulsion d'énergie, toujours exactement avec un trajet de décharge (G), et **en ce que**, de préférence dans les pauses entre impulsions d'énergie, une commutation est effectuée vers un autre trajet de décharge.

3. Installation selon la revendication 1 ou 2, **caractérisée en** outre ce que l'inductance (32) est chargée uniquement pendant la fourniture des impulsions d'énergie.

4. Installation selon la revendication 1 ou 2, **caractérisée en outre en ce que** l'inductance (32) est chargée uniquement pendant les pauses entre les impulsions d'énergie.

5. Installation de selon l'une des revendications précédentes, **caractérisée en outre en ce que** le dispositif d'alimentation d'énergie (30) comprend un circuit de limitation de tension de sortie (33).

6. Installation selon l'une des revendications précédentes, **caractérisée en outre en ce que** le dispositif d'alimentation d'énergie comprend un moyen de commutation électronique pour la fourniture d'impulsions d'énergie de polarité quelconque au trajet de décharge.

7. Installation selon l'une des revendications précédentes, **caractérisée en outre en ce qu'**au moins un circuit de correction de distorsion est agencé entre ladite au moins une inductance du dispositif d'alimentation d'énergie et ladite au moins une chambre de décharge, afin de supprimer ou de compenser les effets parasites des hautes fréquences ou leurs influences, comme par exemple l'inductance des conducteurs électriques, la capacité de la chambre de décharge ou des électrodes, et analogues.

8. Installation selon l'une des revendications précédentes, **caractérisée en outre en ce que** plusieurs chambres de décharge sont agencées les unes derrière les autres, à travers lesquelles traverse le matériau sans fin, sans entrer en contact dans les chambres de décharge ou entre celles-ci.

9. Installation selon l'une des revendications précédentes, **caractérisée en outre en ce qu'**il est prévu un agencement magnétique (6, 6') à haute puissance qui engendre, dans la région de l'électrode extérieure (5), un champ magnétique intense, orienté sensiblement parallèlement au matériau sans fin, d'au moins 120 mT, de préférence au moins 400 mT, de la façon la plus préférée au moins 700 mT.

10. Installation selon la revendication 9, **caractérisée en outre en ce que** l'agencement magnétique à haute puissance (6') est réalisé pour engendrer un champ magnétique sensiblement homogène sur le tracé de son extension longitudinale.

11. Installation selon la revendication 10, **caractérisée en outre en ce que** l'agencement magnétique à haute puissance (6') est une bobine (63) qui entoure l'électrode extérieure et qui est agencée sensiblement coaxialement avec le matériau sans fin (1), ladite bobine étant de préférence réalisée comme une bobine refroidie, en particulier refroidie par un liquide, et en option sous forme d'électroaimant supraconducteur.

12. Installation selon la revendication 9, **caractérisée en outre en ce que** l'agencement magnétique à haute puissance (6) est réalisé pour engendrer un champ magnétique non homogène sur le tracé de son extension longitudinale, dont les maxima déterminent les maxima de l'intensité du traitement du matériau sans fin.

13. Installation selon la revendication 12, **caractérisée en outre en ce que** l'agencement magnétique à haute puissance (6) est réalisé sous forme d'agencement à aimant permanent qui comprend des aimants permanents (61) en particulier anisotropes, de préférence des aimants permanents NdFeB, qui forment sensiblement les parois latérales d'un prisme à section polygonale.

14. Installation selon la revendication 13, **caractérisée en outre en ce qu'**il est prévu des éléments de bouclage en fer (62), qui concentrent le champ magnétique de l'agencement à aimant permanent (6) dans la zone de la décharge, de sorte que la direction en aimantation des aimants est de préférence orientée sensiblement radialement par rapport à la section du prisme.

15. Installation selon l'une des revendications 9 à 14, **caractérisée en outre en ce que** l'électrode extérieure (5) ne dépasse pas dans son extension longitudinale hors du champ magnétique.

16. Installation selon l'une des revendications 9 à 14, **caractérisée en outre en ce que** l'électrode extérieure dépasse dans son extension longitudinale sur au moins un côté hors du champ magnétique.

17. Installation selon l'une des revendications précédentes, **caractérisée en outre en ce que** l'électrode extérieure (5, 51-55, 56, 57) enveloppe le matériau sans fin sensiblement totalement dans la projection sur le plan de sa section transversale, de façon optiquement opaque.

18. Installation selon la revendication 17, **caractérisée en ce que** l'électrode extérieure (5) définit une partie de la chambre de décharge et peut de préférence être refroidie, en particulier refroidie par un liquide.

19. Installation selon la revendication 17 ou 18, **caractérisée en outre en ce que** le rapport entre la surface de section transversale à l'intérieur de l'électrode extérieure (5, 51-57) et la surface de section transversale des plus petites enveloppantes convexes du matériau sans fin (1) est au moins 4:1, de préférence au moins 10:1, et de façon encore plus préférée au moins 20:1.

20. Installation selon l'une des revendications précédentes, **caractérisée en outre en ce que** la pression dans la chambre de décharge est susceptible d'être réglée à 0,1 à 100 mbar, de façon préférée à 0,5 à 50 mbar, et de la façon la plus préférée à 1 à 10 mbar.

21. Installation selon l'une des revendications précédentes, dans laquelle le dispositif pour régler une atmosphère gazeuse comprend un système à chambres antérieures et/ou un système à chambres postérieures, dans laquelle des ouvertures à sas sont prévues entre les chambres de ces systèmes, ouvertures à travers lesquelles le matériau sans fin peut être passé,
**caractérisée en ce qu'**au moins une ouverture à sas est réalisée sous forme de tunnel (41) qui présente de préférence entre la longueur du tunnel et la largeur libre du tunnel un rapport d'au moins 2:1, de préférence au moins 4:1, et qui peut être réalisé aussi bien sous forme d'élément structurel autonome que sous une forme de réalisation particulière d'autres éléments structurels.

22. Installation selon la revendication 21, **caractérisée en outre en ce que** ceux des sas dans lesquels règnent sur les deux côtés une
dépression et des compositions gazeuses différentes sont réalisés sous forme de tunnels (41).

23. Installation selon la revendication 21 ou 22, **caractérisée en outre en ce que** les moyens pour régler une atmosphère gazeuse comprennent un système de récupération dans lequel du gaz provenant d'une chambre postérieure peut être mis en recirculation dans une chambre antérieure et/ou dans une chambre postérieure avec un niveau de pression plus élevé.

24. Installation selon la revendication 23, **caractérisée en outre en ce que** les chambres antérieures sont subdivisées en sous-chambres et/ou en ce que le système de chambres postérieures se compose de chambres postérieures individuelles, dans laquelle des ouvertures à sas sont prévues entre les sous-chambres ou respectivement les chambres postérieures, ouvertures via lesquels le matériau sans fin peut être amené à traverser les sous-chambres ou les chambres postérieures avec peu de friction.
